# EUROPEAN PATENT APPLICATION

(11) **EP 4 628 827 A1**
(43) Date of publication of application: **08.10.2025**
(21) Application number: 23897744.1
(22) Date of filing: 27.11.2023
(51) Int. Cl.: F28D 15/02, F28D 15/04

(54) **HEAT EXCHANGER, MANUFACTURING METHOD, AND DEVICE**

(30) Priority: 29.11.2022 JP 2022190760; 29.11.2022 JP 2022190761
(71) Applicant: NATIONAL UNIVERSITY CORPORATION TOKAI NATIONAL HIGHER EDUCATION AND RESEARCH SYSTEM, Nagoya-shi, Aichi 464-8601 (JP); Porite Corporation, Saitama-shi, Saitama 331-0823 (JP)
(72) Inventor: NAGANO Hosei, Nagoya-shi Aichi 464-8601 (JP); WATANABE Noriyuki, Nagoya-shi Aichi 464-8601 (JP); TANABE Shigeyuki, Saitama City Saitama 331-0823 (JP); ASO Shinobu, Saitama City Saitama 331-0823 (JP); SADAKATA Kazuki, Saitama City Saitama 331-0823 (JP)
(74) Representative: Kuhnen & Wacker Patent- und Rechtsanwaltsbüro PartG mbB
(86) International application number: PCT/JP2023/042431
(87) International publication number: WO 2024/117096

(57) **Abstract**

The present disclosure provides a heat exchanger including an evaporator provided with an evaporating body configured to absorb heat from outside and evaporate a liquid-phase working fluid into a gas phase while moving the working fluid by capillary forces, the heat exchanger being configured to condense the gas-phase working fluid introduced from the evaporator and circulate the working fluid in a liquid phase back into the evaporator. The evaporator includes: a plate-shaped main body including a recess in a plate surface thereof, the recess being configured to accommodate the evaporating body; and a lid body configured to cover the recess and the evaporating body accommodated in the recess. The main body includes a structural portion configured to make an outer depth of the recess shallower than its center depth. An outer portion of the evaporating body accommodated in the recess is sandwiched by the structural portion and the lid body.

## Description

### Technical Field

The present disclosure relates to a heat exchanger, a manufacturing method, and a device.

### Background Art

Patent Document 1 discloses a loop heat pipe including an evaporator, a condenser, a liquid return pipe, and a wick that is located inside the evaporator and generates capillary forces in order to efficiently cool heating elements regardless of an installation angle.

### Citation List

### Patent Literature

Patent Document 1: Japanese Patent Application Laid-Open Publication No. 2008-215702

### Summary of Invention

### Technical Problem

Recent miniaturization and increased performance of devices, such as electronic devices, has led to an increased heat density of heating elements provided in the devices. In addition, a trend toward thinner-profile devices, for example, has been accompanied by the need for a heat exchanger that can remove heat flux from heating elements while having a reduced thickness dimension.

The techniques disclosed herein aim to provide a method for manufacturing a heat exchanger and the like with a reduced thickness dimension.

### Solution to Problem

To solve the above problem, the techniques disclosed herein provide a heat exchanger including an evaporator provided with an evaporating body, the evaporating body being configured to absorb heat from outside and evaporate a liquid-phase working fluid into a gas phase while moving the working fluid by capillary forces, the heat exchanger being configured to condense the gas-phase working fluid introduced from the evaporator and circulate the working fluid in a liquid phase back into the evaporator. The evaporator includes: a plate-shaped main body including a recess in a plate surface thereof, the recess being configured to accommodate the evaporating body; and a lid body configured to cover the recess of the main body and the evaporating body accommodated in the recess. The main body includes a structural portion configured to make an outer depth of the recess shallower than a center depth of the recess. An outer portion of the evaporating body accommodated in the recess is sandwiched by the structural portion and the lid body.

### Advantageous Effects of Invention

With the techniques disclosed herein, it is possible to manufacture a heat exchanger and the like with a reduced thickness dimension.

### Brief Description of Drawings

FIG. 1 illustrates a schematic configuration of a loop heat pipe according to an exemplary embodiment.
FIGS. 2 is an exploded perspective view of the loop heat pipe.
FIG. 3 illustrates a detailed configuration of a first side plate and a second side plate.
FIG. 4 illustrates a configuration around a wick.
FIG. 5 illustrates a configuration of a first support and a second support.
FIG. 6 illustrates a schematic configuration of a mask.
FIG. 7 illustrates steps for forming the wick on the first side plate.
FIG. 8 illustrates steps for forming a bonding member on the second side plate.
FIG. 9 illustrates steps for bonding the wick and the bonding member.
FIG. 10 illustrates a configuration of the wick.
FIG. 11 illustrates a configuration of support posts.
FIG. 12 illustrates steps for forming the support posts.
FIG. 13 illustrates a configuration of a fin.
FIG. 14 illustrates a device equipped with the loop heat pipe.
FIG. 15 illustrates variants of the exemplary embodiment.

### Description of Embodiments

An exemplary embodiment will now be described with reference to the drawings.

### <Schematic Configuration of Loop Heat Pipe 1>

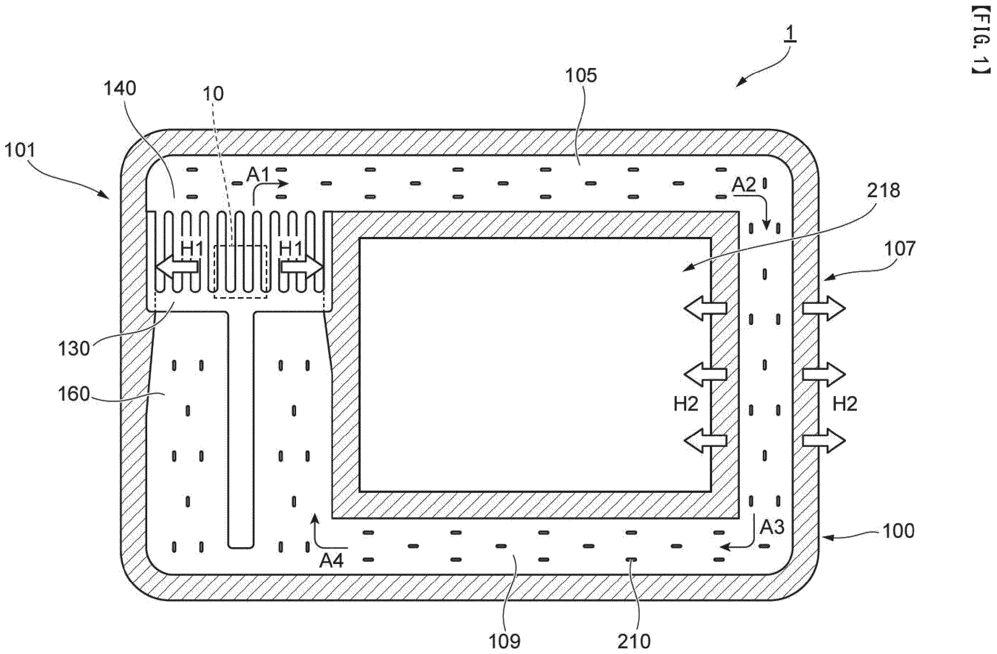

FIG. 1 illustrates a schematic configuration of a loop heat pipe 1 according to an exemplary embodiment.

Referring initially to FIG. 1, a configuration of the loop heat pipe 1 according to an exemplary embodiment will be described. The loop heat pipe 1 according to the present embodiment is a heat exchanger that is configured to circulate a working fluid therein to cool a heating element 10, such as a central processing unit (CPU) in an electronic device, without external power supply.

More specifically, the loop heat pipe 1 includes an evaporator 101 configured to evaporate the working fluid to cool the heating element 10 using the latent heat of vaporization of the working fluid, and a condenser 107 configured to dissipate the heat of the working fluid vaporized in the evaporator 101 to liquefy it.

The loop heat pipe 1 further includes a vapor line 105 configured to deliver the working fluid vaporized in the evaporator 101 to the condenser 107, and a liquid line 109 configured to deliver the working fluid liquefied in the condenser 107 to the evaporator 101. The loop heat pipe 1 is filled with the working fluid that changes between liquid and vapor phases. For example, the working fluid may be water, alcohol (e.g., ethanol), ammonia, acetone, etc.

### <Operation of Loop Heat Pipe 1>

Referring next to FIG. 1, the operation of the loop heat pipe 1 will be described.

Heat generated in the heating element 10 is transferred to the evaporator 101 (see arrows H1). The working fluid having absorbed the heat in the evaporator 101 is vaporized and delivered through the vapor line 105 (see arrow A1) to the condenser 107 (see arrow A2). The working fluid delivered to the condenser 107 dissipates its heat (see arrows H2) and liquefies. The liquefied working fluid is then delivered through the liquid line 109 (see arrow A3) back to the evaporator 101 (see arrow A4). As such, the loop heat pipe 1 functions as a non-powered fluid device. To further illustrate, the loop heat pipe 1 is a two-phase heat transport device driven by the capillary forces of the fluid.

### <Detailed Configuration of Loop Heat Pipe 1>

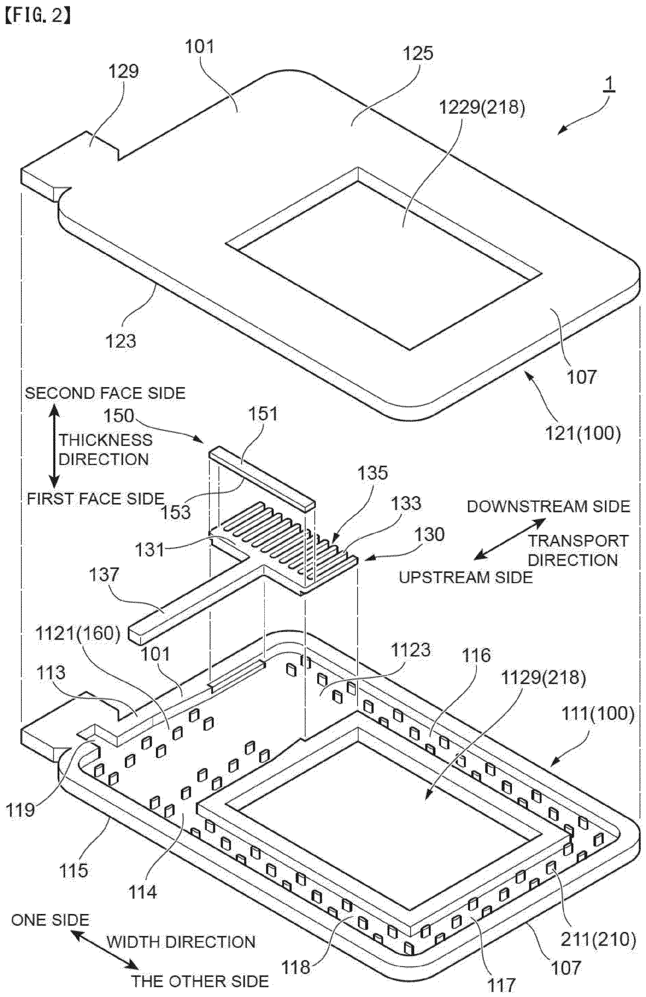

FIG. 2 is an exploded perspective view of the loop heat pipe 1.

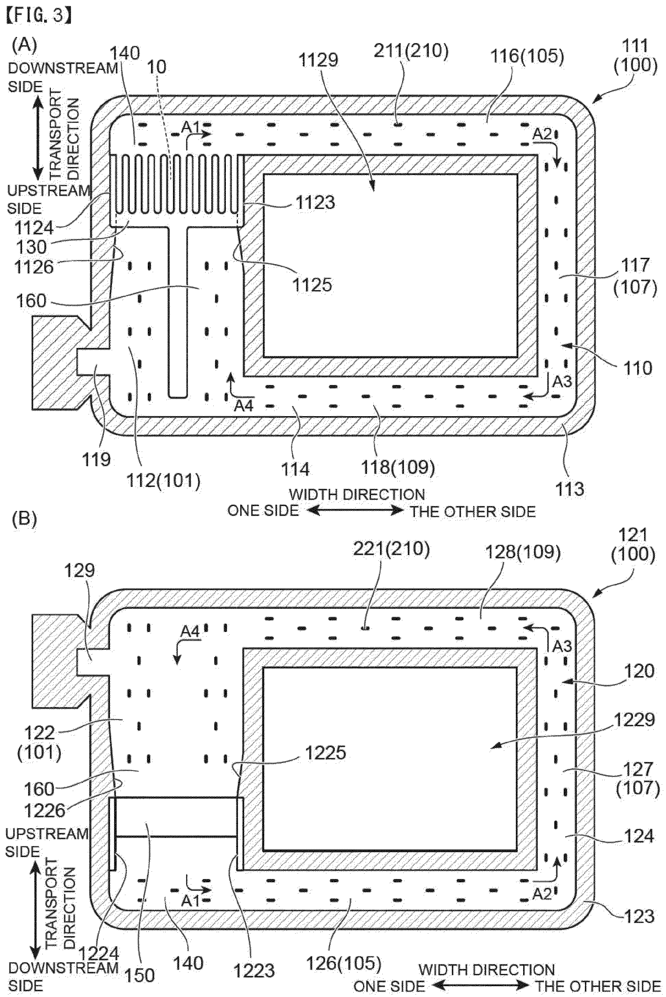

FIG. 3 illustrates a detailed configuration of a first side plate 111 and a second side plate 121.

Referring next to FIGS. 2 and 3, a detailed configuration of the loop heat pipe 1 according to the present embodiment will be described.

The loop heat pipe 1 according to the present embodiment has a generally planar shape. As shown in FIG. 2, the loop heat pipe 1 includes a wick 130 and a bonding member 150 inside a housing 100 of a generally planar shape. The housing 100 includes a first side plate 111 and a second side plate 121, each having a generally planar shape. The wick 130 and the bonding member 150 also each have a generally planar shape. These wick 130 and bonding member 150 are sandwiched by the first and second side plates 111, 121.

The first side plate 111 includes a first inner surface 113 and a first outer surface 115, each having a generally rectangular shape in a front view. The first side plate 111 further includes a first through-hole 1129 formed through its opposite plate surfaces. The first through-hole 1129 is a generally rectangular hole in a plan view, formed substantially at the center of the plate surface of the first side plate 111.

The second side plate 121 includes a second inner surface 123 and a second outer surface 125, each having a generally rectangular shape in a front view. The second side plate 121 further includes a second through-hole 1229 formed through its opposite plate surfaces. The second through-hole 1229 is a generally rectangular hole in a plan view, formed substantially at the center of the plate surface of the second side plate 121. The second through-hole 1229 is located at a position facing the first through-hole 1129 when the first and second side plates 111, 121 are stacked face-to-face. To further illustrate, the first and second through-holes 1129, 1229 face each other to form a through-hole 218.

The first and second side plates 111, 121 may be made of, but is not limited to, a metal material such as copper, copper alloy, stainless steel, titanium, and titanium alloy. The wick 130 and the bonding member 150 are disposed in a stack between the first inner surface 113 of the first side plate 111 and the second inner surface 123 of the second side plate 121.

The loop heat pipe 1 can diffuse heat using the first and second side plates 111, 121. The loop heat pipe 1 is of a generally planar shape with a thickness of, e.g., less than or equal to 1 mm. Additionally, the loop heat pipe 1 is dimensioned to allow it to be installed in mobile terminals such as smartphones or in so-called plastic cards such as credit cards. Specifically, in an implementation where the loop heat pipe 1 is installed in a mobile terminal, it is formed in a so-called thin plate shape, with overall dimensions of 100 mm or less in length, 60 mm or less in width, and 0.3 mm or less in thickness, for example. In another implementation where the loop heat pipe 1 is installed in a plastic card, it is formed in a so-called thin plate shape, with overall dimensions of 79 mm or less in length, 52 mm or less in width, and 0.3 mm or less in thickness, for example. To further illustrate, the loop heat pipe 1 is dimensioned with a thickness of, e.g., 5% or less, preferably 1% or less, and more preferably 0.3% or less, of its planar dimension (e.g., length or width).

The thickness direction of the loop heat pipe 1, i.e., the vertical direction in FIG. 2, may be hereinafter referred to simply as the thickness direction. The lower side in the vertical direction in FIG. 2 may be referred to as the first face side, and the upper side in FIG. 2 may be referred to as the second face side. The direction in which the working fluid is transported through the wick 130 in the evaporator 101 (the flow direction), i.e., the direction extending between the lower left and the upper right in FIG. 2, may be referred to as the transport direction (flow direction). The lower left side in FIG. 2 may be referred to as the upstream side, and the upper right side may be referred to as the downstream side. The direction intersecting the vertical direction and the transport direction, i.e., the direction extending between the upper left and the lower right in FIG. 2 may be referred to as the width direction. The upper left side in FIG. 2 may be referred to as one side, and the lower right side may be referred to as the other side.

As shown in FIG. 3(A), the first side plate 111 includes a first recess 110 formed in the first inner surface 113. The first recess 110 is an annular region formed around the periphery of the first through-hole 1129 in the first inner surface 113. To further illustrate, the first recess 110 includes a first evaporator region 112, a first vapor line region 116, a first condenser region 117, a first liquid line region 118, and a first opening region 119, which are annularly continuous on the first inner surface 113 of the first side plate 111.

As shown in FIG. 3(B), the second side plate 121 includes a second recess 120 formed in the second inner surface 123. The second recess 120 is an annular region formed around the periphery of the second through-hole 1229 in the second inner surface 123. The second recess 120 is shaped as a mirror image of the first recess 110. In other words, the first and second recesses 110, 120 are in a mirror-symmetric relationship. To further illustrate, the second recess 120 includes a second evaporator region 122, a second vapor line region 126, a second condenser region 127, a second liquid line region 128, and a second opening region 129, which are annularly continuous on the second inner surface 123 of the second side plate 121.

When the first inner surface 113 of the first side plate 111 and the second inner surface 123 of the second side plate 121 are positioned face-to-face, the first and second recesses 110, 120 confront each other. In this arrangement, the first and second evaporator regions 112, 122 form the evaporator 101. Likewise, the first and second vapor line regions 116, 126 form the vapor line 105. The first and second condenser regions 117, 127 form the condenser 107. The first and second liquid line regions 118, 128 form the liquid line 109.

In addition, multiple first support posts 211 are formed on a first bottom surface 114 of the first recess 110. In the illustrated example, the first support posts 211 are formed in each of the first evaporator region 112, the first vapor line region 116, the first condenser region 117, and the first liquid line region 118. Also, multiple second support posts 221 are formed on a second bottom surface 124 of the second recess 120. In the illustrated example, the second support posts 221 are formed in each of the second evaporator region 122, the second vapor line region 126, the second condenser region 127, and the second liquid line region 128.

When the first inner surface 113 of the first side plate 111 and the second inner surface 123 of the second side plate 121 are positioned face-to-face, the first support posts 211 confront the corresponding second support posts 221. To further illustrate, the distal ends of the first support posts 211 are brought into abutting contact with the distal ends of the corresponding second support posts 221. This abutment between the first and second support posts 211, 221 prevents contact between the first bottom surface 114 of the first recess 110 of the first side plate 111 and the second bottom surface 124 of the second recess 120 of the second side plate 121. That is, the first and second support posts 211, 221 support the interior of the evaporator 101, the vapor line 105, the condenser 107, and the liquid line 109. In other words, the first and second support posts 211, 221 prevent deformation of the evaporator 101, the vapor line 105, the condenser 107, and the liquid line 109. To further illustrate, the first and second support posts 211, 221 have a function of preventing blockage or narrowing of the flow path of the working fluid inside the evaporator 101 and other components, which may otherwise be caused by the negative pressure created inside the evaporator 101, the vapor line 105, the condenser 107, and the liquid line 109. In the illustrated example, the distal ends of the first support posts 211 and the distal ends of the second support posts 221 are joined together. This prevents separation (detachment) between the first inner surface 113 of the first side plate 111 and the second inner surface 123 of the second side plate 121. Hereinafter, the combination of the first support post 211 and the second support post 221 may be referred to as a support post 210.

The first and second opening regions 119, 129 in the illustrated example form an opening that allows for injection of the working fluid into the first and second recesses 110, 120 from outside after joining the first inner surface 113 of the first side plate 111 and the second inner surface 123 of the second side plate 121. To further illustrate, the opening formed by the first and second opening regions 119, 129 is sealed after the injection of the working fluid. More specifically, while the first and second opening regions 119, 129 are shown as being formed in FIG. 2 and other figures for the sake of illustration, they are sealed in the completed loop heat pipe 1 (see FIG. 1).

The evaporator 101 formed by the first and second evaporator regions 112, 122 will now be described.

Each of the first and second evaporator regions 112, 122 has a generally rectangular shape in a plan view. Thus, the interior of the evaporator 101 formed by the first and second evaporator regions 112, 122 is a generally cuboid space. The wick 130 is disposed inside the evaporator 101. By disposing the wick 130, the interior of the evaporator 101 is divided into a space closer to the liquid line 109 and a space closer to the vapor line 105, with the wick 130 in between. In the interior of the evaporator 101, the space closer to the liquid line 109 than the wick 130 serves as a liquid reservoir 160, in which the liquid-phase working fluid is contained. In the interior of the evaporator 101, the space closer to the vapor line 105 than the wick 130 serves as a vapor space 140, through which the gas-phase working fluid passes.

### <Configuration of Evaporator 101 >

### <Configuration around Wick 130>

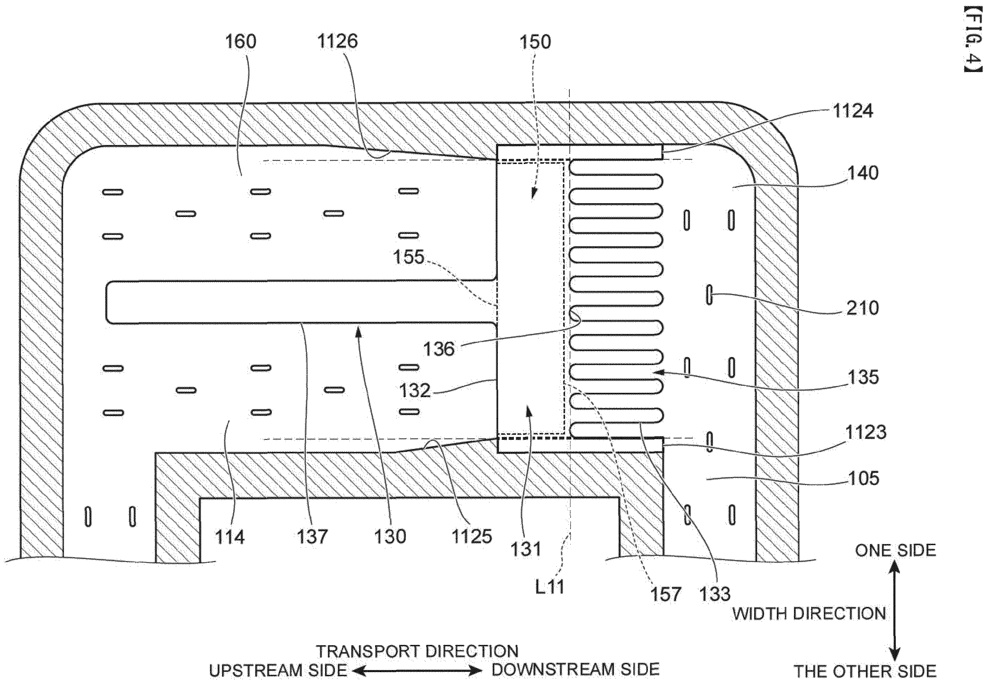

FIG. 4 illustrates a configuration around the wick 130.

Referring next to FIGS. 3 and 4, a configuration of the wick 130 and its surrounding components will be described.

The wick 130 is made of a porous body, such as a porous metal of copper or the like. The wick 130 generates capillary forces in the working fluid, causing the working fluid to move. The effective pore size of the wick 130 is 0.1 to 50 µm. The effective pore size of the wick 130 is preferably 3.5 to 49 µm, more preferably 5 to 45 µm, and even more preferably 20 to 40 µm. The porosity of the wick 130 is 20 to 90%, preferably 25 to 80%. Any method may be used to measure the effective pore size and porosity. For example, the effective pore size and porosity may be measured based on apparent density measurement by water immersion, pore size distribution measurement by mercury porosimetry, or pore observation by X-ray CT.

As shown in FIG. 4, the wick 130 generally has a rake shape (fork shape). Specifically, the wick 130 includes a generally rectangular wick base 131 with its longitudinal direction extending along the width direction, wick prongs 133 protruding downstream in the transport direction from the wick base 131, and a wick protrusion 137 protruding upstream in the transport direction from the wick base 131. In the illustrated example, multiple wick prongs 133 are provided at predetermined intervals in the width direction. In other words, the wick 130 includes multiple slits 135 located downstream in the transport direction and extending along the transport direction. The upstream end in the transport direction of the slit 135 may be referred to as a slit bottom 136. In the illustrated example, the wick protrusion 137 is formed at the center in the width direction of the wick base 131.

Here, the wick base 131 and the wick prongs 133 of the illustrated wick 130 have a generally comb-like shape. The slits 135 of the comb-like wick 130 serve as vapor grooves, or so-called grooves, that facilitate the flow of the working fluid vaporized in the wick 130 toward the vapor line 105. More specifically, in the illustrated example, the wick prongs 133 and the slits 135 are alternately arranged in the same plane, which allows the wick 130, the first side plate 111, and the second side plate 121 to be thinner while maintaining the mechanical strength, compared to e.g., arranging the wick prongs 133 and the slits 135 in the thickness direction. It is even more preferable that the wick prongs 133 are in contact with both the first and second side plates 111, 121 as a result of providing the wick prongs 133 and the slits 135 in the same plane. This improves the flexibility in disposing the heating element 10 (FIG. 1), which is the heat source. That is, with this configuration where the wick prongs 133 can receive heat from both the first and second side plates 111, 121, the heating element 10 may be located on either or both of the first outer surface 115 of the first side plate 111 and the second outer surface 125 of the second side plate 121.

To further illustrate, the distal ends of the wick prongs 133 and the slit bottoms 136 in the illustrated example are rounded (curved). As will be detailed below, the wick 130 is formed by applying a metal paste. Such a curved shape of the distal ends of the wick prongs 133 and the slit bottoms 136 facilitates the application of metal paste, compared to when, e.g., they are angular rather than curved.

Here, if, for example, the liquid reservoir 160 contains a small amount of working fluid, the working fluid may be unevenly distributed in the liquid reservoir 160. Such uneven distribution of the working fluid may inhibit it from being supplied to the wick 130, with the consequent risk of degrading the operating performance of the wick 130. Hence, the wick 130 in the illustrated example is formed with the wick protrusion 137. Forming the wick protrusion 137, which protrudes into the liquid reservoir 160, may ensure a stable supply of the working fluid to the wick base 131 and the wick prongs 133 via the wick protrusion 137, even when the working fluid is unevenly distributed within the liquid reservoir 160.

The wick protrusion 137 can be viewed as another wick, or a secondary wick, for supplying the working fluid to the wick base 131 and other portions. The wick protrusion 137 may be of any material, shape (e.g., pillar or mesh form), etc. that can provide a structure with predetermined capillary forces. The wick protrusion 137 may be dimensioned such that flow pressure loss is not greater than a predetermined value.

To further illustrate, the wick 130 is dimensioned with a thickness of 0.01 mm to 1 mm, more preferably with a thickness of 0.1 mm to 0.2 mm. Here, the wick base 131 of the wick 130 is, for example, 10 mm to 300 mm long in the width direction and 1 mm to 100 mm long in the transport direction. The wick base 131 is dimensioned such that its thickness is, for example, 0.01 to 100%, more preferably 0.1 to 10%, of its length in the transport direction. In the illustrated example, the wick 130 is 0.2 mm thick. The wick 130 is 21 mm long in the width direction and 2 mm long in the transport direction

Each wick prong 133 is 0.5 mm to 2.0 mm long in the width direction and 10 mm to 20 mm long in the transport direction. Each slit 135 is 0.5 mm to 2.0 mm long in the width direction, for example. To further illustrate, each slit 135 has approximately the same length as each wick prong 133 in the width direction. In the illustrated example, the heating element 10 (see FIG. 1) is, for example, 10 mm wide and 10 mm long. Accordingly, the region of the wick 130 where the wick base 131 and the multiple wick prongs 133 are provided is larger in width and length than the heating element 10.

The wick protrusion 137 is 1 mm to 30 mm long in the width direction and 10 mm to 100 mm long in the transport direction. In the illustrated example, the wick protrusion 137 is larger than each wick prong 133 in the width direction. The wick protrusion 137 is also larger than each wick prong 133 in the transport direction.

As described above, the wick 130 is disposed inside the housing 100. The wick 130 is sandwiched by the first and second side plates 111, 121 in the thickness direction. Inside the housing 100, i.e., between the first and second side plates 111, 121, the wick 130 also provides a partition between the vapor space 140 and the liquid reservoir 160. Here, if a gap is created between the inner surface of the housing 100 and the wick 130, more specifically, between the first side plate 111 and the wick 130 or between the second side plate 121 and the wick 130, the liquid-phase working fluid may flow (leak) into the vapor space 140 or the gas-phase working fluid may flow into (flow back into) the liquid reservoir 160. Such inflow would reduce the heat exchange rate of the loop heat pipe 1.

Hence, in the present embodiment, the wick 130 is formed on the first side plate 111 by applying a material for use as the wick 130 to the first inner surface 113 of the first side plate 111 (details will be given below). This prevents a gap from being created between the wick 130 and the first inner surface 113 of the first side plate 111.

Additionally, in the present embodiment, a bonding member 150 is disposed over the wick 130. This prevents a gap from being created between the wick 130 and the second inner surface 123 of the second side plate 121.

Additionally, in the present embodiment, a first support 1123 and a second support 1124 are formed on the first bottom surface 114 of the first recess 110 provided in the first side plate 111. Also, a third support 1223 and a fourth support 1224 are formed on the second bottom surface 124 of the second recess 120 provided in the second side plate 121 (see FIG. 3(B)). These first support 1123, second support 1124, third support 1223, and fourth support 1224 serve to prevent the creation of gaps at both ends of the wick 130 in the width direction.

Now, as shown in FIG. 4, the bonding member 150 is a generally rectangular plate-shaped member with its longitudinal direction extending along the width direction. In the illustrated example, the bonding member 150 is 2 mm long in the transport direction and 19 mm long in the width direction. The bonding member 150 is made of a metal such as copper or bronze.

Here, the bonding member 150 is located to cover the wick base 131 of the wick 130. To further illustrate, a bonding member upstream end face 155 of the bonding member 150 is aligned with an upstream end face 132 of the wick base 131 in the transport direction. In the transport direction, a bonding member downstream end face 157 of the bonding member 150 is located downstream of the upstream end face 132 and upstream of a virtual line L11 extending along the slit bottoms 136. If the bonding member downstream end face 157 is located upstream of the upstream end face 132 in the transport direction, leakage of the working fluid may occur. If the bonding member downstream end face 157 is located downstream of the virtual line L11 in the transport direction, the function of the slits 135 may degrade.

### <First Support 1123 and Second Support 1124>

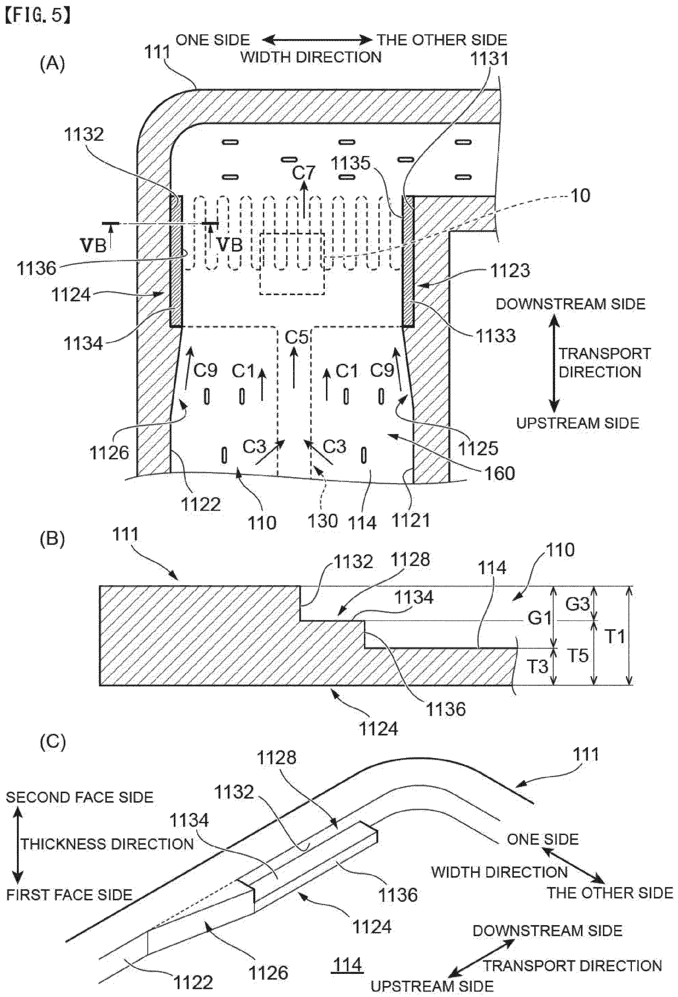

FIG. 5 illustrates a configuration of the first support 1123 and the second support 1124.

Referring now to FIG. 5, a configuration of the first and second supports 1123, 1124 will be described. More specifically, FIG. 5(A) is a plan view around the first and second supports 1123, 1124, FIG. 5(B) is a cross-sectional view taken along line VB-VB of FIG. 5(A), and FIG. 5(C) is a perspective view around the second support 1124.

As shown in FIG. 5(A), the first and second supports 1123, 1124 each have a generally cuboid shape and are formed on the first bottom surface 114 of the first recess 110. The first and second supports 1123, 1124 are formed with their longitudinal directions extending along the transport direction. The first and second supports 1123, 1124 are formed in a spaced-apart relationship from each other in the width direction. The regions where the first and second supports 1123, 1124 are formed face the respective ends in the width direction of the wick 130.

The first support 1123 is a portion protruding in the width direction from a first facing surface 1131, which is an inner side surface of the first recess 110. The first support 1123 includes a first support upper surface 1133 facing upward in the thickness direction and a first support side surface 1135 facing one side in the width direction.

The second support 1124 is a portion protruding in the width direction from a second facing surface 1132, which is another inner side surface of the first recess 110. The second support 1124 includes a second support upper surface 1134 facing upward in the thickness direction and a second support side surface 1136 facing the other side in the width direction.

Here, the first and second support upper surfaces 1133, 1134 are generally rectangular flat surfaces. A generally cuboid space is created above each of the first and second support upper surfaces 1133, 1134. These spaces can be viewed as cut-outs 1128 made in the first side plate 111 (see FIG. 5(B)). As will be detailed below, the ends of the wick 130 in the width direction are situated in the respective cut-outs 1128.

### <First Taper 1125 and Second Taper 1126>

Referring next to FIG. 5, a configuration of a first taper 1125 and a second taper 1126 will be described.

Although not described above, as shown in FIG. 5, a first taper 1125 is formed on the first recess 110 at a position upstream of the first support 1123 in the transport direction and adjacent to the first support 1123. Also, a second taper 1126 is formed on the first recess 110 at a position upstream of the second support 1124 in the transport direction and adjacent to the second support 1124. In addition, a third taper 1225 and a fourth taper 1226 are formed on the second recess 120 at positions upstream of the third support 1223 and the fourth support 1224, respectively, in the transport direction (see FIG. 3(B)). The third taper 1225 and the fourth taper 1226 are shaped as mirror images of the first taper 1125 and the second taper 1126, respectively. These first taper 1125, second taper 1126, third taper 1225, and fourth taper 1226 are configured to guide the working fluid.

The first and second tapers 1125, 1126 are detailed below as examples. As shown in FIG. 5(A), the first taper 1125 is inclined away from the first side surface 1121 as one moves toward the downstream side in the transport direction. The second taper 1126 is inclined away from the second side surface 1122 as one moves toward the downstream side in the transport direction. The first and second tapers 1125, 1126 guide the flow of the working fluid. To further illustrate, the flow path of the working fluid is narrowed in the width direction by the first and second tapers 1125, 1126 as one moves toward the downstream side in the transport direction. Thus, the working fluid moving downstream in the transport direction within the first recess 110 is guided toward the center in the width direction by the first and second tapers 1125, 1126 (see arrows C9 in FIG. 5(A)).

### <Operation of Evaporator 101>

Referring next to FIG. 5(a), an operation of the evaporator 101 will be described.

First, the liquid-phase working fluid contained in the liquid reservoir 160 flows toward the wick base 131 (see arrows C1) and permeates the wick base 131. Also, a portion of the liquid-phase working fluid contained in the liquid reservoir 160 permeates the wick protrusion 137 (see arrows C3) and flows toward the wick base 131 while moving through the wick protrusion 137 by capillary forces (see arrow C5). Another portion of the liquid-phase working fluid contained in the liquid reservoir 160 flows toward the wick base 131 while being guided by the first taper 1125, the second taper 1126, the third taper 1225, and the fourth taper 1226 (see arrows C9).

The liquid-phase working fluid is then heated and vaporized by the heat of the heating element 10 as it moves through the wick base 131 due to capillary forces of the wick base 131. The vaporized working fluid passes through the slits 135 and other portions toward the vapor line 105 (see arrow C7) and then flows through and exits the vapor line 105 for delivery to the condenser 107 (see FIG. 1). The working fluid liquefied in the condenser 107 (see FIG. 1) then flows into the evaporator 101 and goes through the liquid reservoir 160 to permeate the wick 130 again. In this manner, the above cycle is repeated without interruption of the flow of the working fluid at the wick 130. The heat generated in the heating element 10 is thus transported from the evaporator 101 to the condenser 107 (see FIG. 1).

### <Steps for Forming First Side Plate 111 and Second Side Plate 121>

Referring next to FIG. 5, steps for forming the first and second side plates 111, 121 will be briefly described.

First, as described above, the first and second side plates 111, 121, which are planar member made of copper or other metal material, are processed to form the first and second recesses 110, 120, respectively. In the illustrated example, a 0.15 mm-thick copper flat plate (see thickness T1 in FIG. 5(B)) is etched to form the first and second recesses 110, 120. Here, the first and second recesses 110, 120 are 0.1 mm in depth (see depth G1 in FIG. 5(B)). That is, the regions in the first and second side plates 111, 121 where the first and second recesses 110, 120 are formed have a bottom thickness of 0.05 mm (see thickness T3 in FIG. 5(B)). To further illustrate, etching is used to remove at least 50% of the thickness of the first and second side plates 111, 121.

As will be detailed below, separately from the etching process for forming the first and second recesses 110, 120, another etching process is performed to form the first support 1123, the second support 1124, the third support 1223, and the fourth support 1224. Here, the depth to the first support upper surface 1133 of the first support 1123 is 0.05 mm (see depth G3 in FIG. 5(B)). That is, the regions in the first and second side plates 111, 121 where the first support 1123, the second support 1124, the third support 1223, and the fourth support 1224 are formed have a bottom thickness of 0.1 mm (see thickness T5 in FIG. 5(B)). This means that, compared to other regions in the first and second recesses 110, 120, the regions where the first support 1123, the second support 1124, the third support 1223, and the fourth support 1224 are formed have a thicker bottom. To further illustrate, the first support 1123, the second support 1124, the third support 1223, and the fourth support 1224 can be viewed as structures that raise the bottoms of the first and second recesses 110, 120.

In the above etching process, the regions where the first and second supports 1123, 1124 are to be formed are masked, thereby forming the first and second supports 1123, 1124 on the first and second recesses 110, 120. Additionally, a through etching, or outer copper plate etching, is performed around the outer shape of the first and second side plates 111, 121 to allow the first and second side plates 111, 121 to be taken out. In the illustrated example, a through etching is also performed to form the first through-hole 1129 in the first side plate 111 and the second through-hole 1229 in the second side plate 121.

### <Steps for Forming Wick 130 and Bonding Member 150>

Referring next to FIG. 4 and 5, steps for forming the wick 130 and the bonding member 150 will be briefly described.

In the present embodiment, the wick 130 and the bonding member 150 are first formed on the first and second side plates 111, 121, respectively, rather than pre-forming the wick 130 and the bonding member 150 and then placing them on the first and second side plates 111, 121, respectively. Then, the first side plate 111 having the wick 130 formed thereon and the second side plate 121 having the bonding member 150 formed thereon are stacked face-to-face to secure the wick 130 and the bonding member 150 to each other.

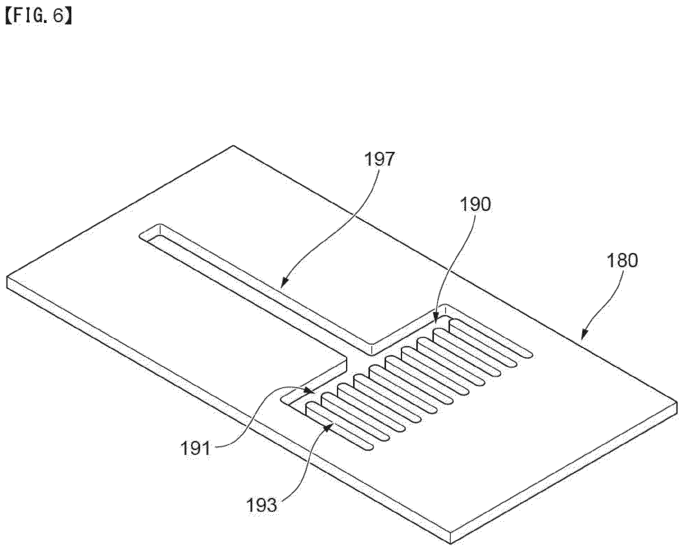

The wick 130 as shown is formed on the first side plate 111 by applying a material of the wick 130 to the first side plate 111 (i.e., by coating the first side plate 111 with a material of the wick 130). To further illustrate, the wick 130 is formed by applying a metal paste containing pure copper powder to a predetermined region in the first side plate 111. A mask 180 (see FIG. 6 below) is used to apply the wick 130.

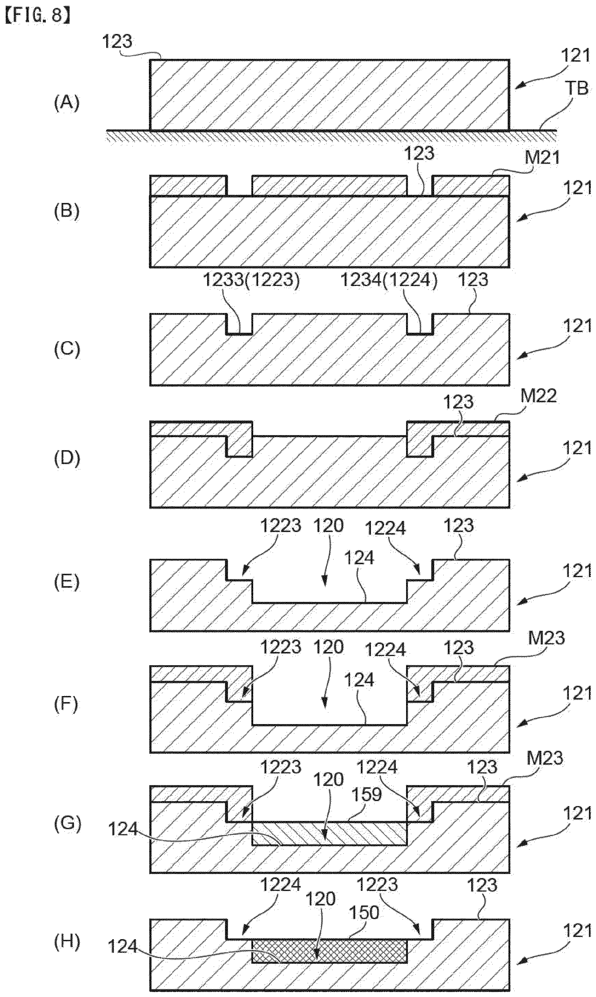

The bonding member 150 as shown is formed on the second side plate 121 by applying a material of the bonding member 150 to the second side plate 121. To further illustrate, the bonding member 150 is formed by applying a metal paste containing copper or bronze powder to a predetermined region in the second side plate 121. Here, the surrounding area of the region where the bonding member 150 is to be formed is masked using any known technique, such as covering the surrounding area with a fifth masking member M23, or a so-called masking tape (see FIG. 8(F) below), before applying the metal paste to form the bonding member 150.

### <Mask 180>

FIG. 6 illustrates a schematic configuration of the mask 180.

For example, the mask 180 is a 0.15 mm-thick planar metal member. The mask 180 includes a wick-shaped opening 190 as a through-hole. The wick-shaped opening 190 includes a wick base region 191 defining the region where the wick base 131 is to be formed, a wick prong region 193 defining the region where the wick prongs 133 are to be formed, and a wick protrusion region 197 defining the region where the wick protrusion 137 is to be formed. The wick base region 191 is a generally rectangular portion with its longitudinal direction extending along the width direction. The wick prong region 193 is a portion protruding downstream in the transport direction from the wick base region 191. The wick protrusion region 197 is portion protruding upstream in the transport direction from the wick base region 191.

The mask 180 is positioned in alignment with the first side plate 111 having the first recess 110 formed therein. Then, the metal paste containing pure copper powder is introduced from above the mask 180 into the wick-shaped opening 190 and applied by, for example, scraping off excess metal paste with a rubber blade (so-called squeegee) or the like. This results in the material of the wick 130 being deposited in the first recess 110 at a predetermined thickness (e.g., 0.25 mm). This applied material of the wick 130 is solidified by sintering or other means to form the wick 130 in the first recess 110. The use of the mask 180 may simplify the steps for forming the wick 130.

### <Steps for Manufacturing Loop Heat Pipe 1>

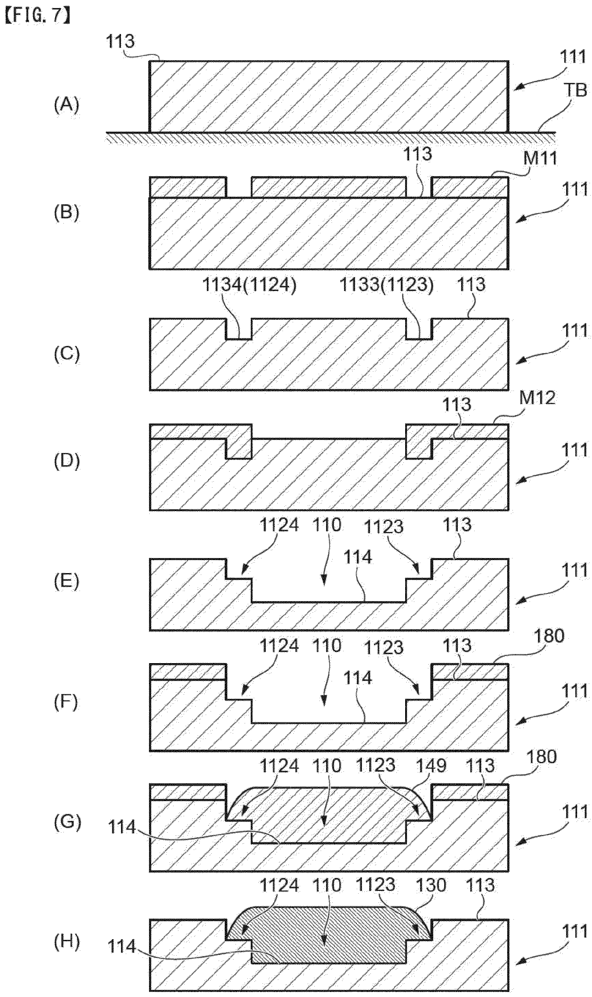

FIG. 7 illustrates steps for forming the wick 130 on the first side plate 111.

FIG. 8 illustrates steps for forming the bonding member 150 on the second side plate 121.

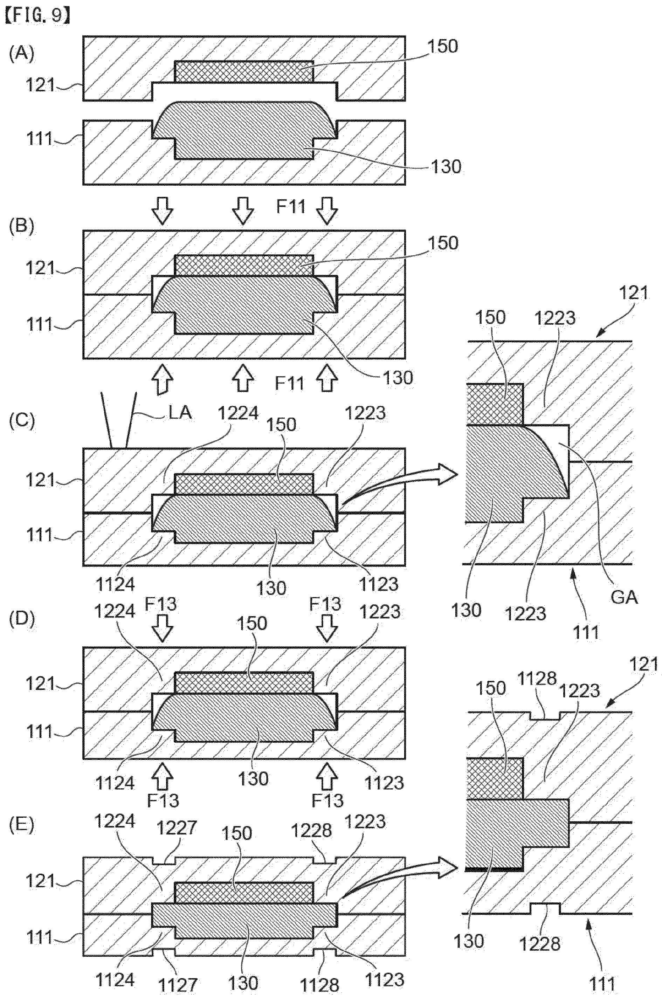

FIG. 9 illustrates steps for bonding the wick 130 and the bonding member 150.

It should be noted that, in FIGS. 7 to 9 in particular, the vertical dimension of each component is exaggerated (enlarged).

Referring now to FIGS. 7 to 9, example steps for the manufacturing the loop heat pipe 1 according to the present embodiment will be described. The steps for manufacturing the loop heat pipe 1 according to the present embodiment includes a forming step of forming the housing 100 composed of the first and second side plates 111, 121, and a filling step of filling the housing 100 with a working fluid.

The forming step includes three sub-steps, namely a step of forming the wick 130 on the first side plate 111, a step of forming the bonding member 150 on the second side plate 121, and a step of bonding the wick 130 formed on the first side plate 111 and the bonding member 150 formed on the second side plate 121. These three steps are discussed below.

### <Step of Forming Wick 130>

Referring first to FIG. 7, the step of forming the wick 130 on the first side plate 111 will be described. In the following steps, the first recess 110, the first support 1123, and the second support 1124 are first formed in the first side plate 111, and then the wick 130 is formed on the first recess 110.

First, steps of forming the first recess 110, the first support 1123, and the second support 1124 in the first side plate 111 will be described. Specifically, as shown in FIG. 7(A), the first side plate 111 is placed on a support table TB. It should be noted that the following steps are carried out while the first side plate 111 is on the support table TB, although it is not illustrated in FIGS. 7(B) to 7(H).

Next, as shown in FIG. 7(B), the region of the first inner surface 113 other than those where the first and second supports 1123, 1124 are to be formed is covered with a first masking member M11. Then, as shown in FIG. 7(C), the first side plate 111 is etched, followed by removing the first masking member M11. The regions etched in this step form the first and second support upper surfaces 1133, 1134.

Next, as shown in FIG. 7(D), the region of the first inner surface 113 other than the region where the first bottom surface 114 of the first recess 110 is to be formed is covered with a second masking member M12. Then, as shown in FIG. 7(E), the first side plate 111 is etched, followed by removing the second masking member M12. The region etched in this step forms the first bottom surface 114. As a result of this step, the first recess 110, the first support 1123, and the second support 1124 are now formed in the first side plate 111.

Next, the wick 130 is formed on the first recess 110, the first support 1123, and the second support 1124. Specifically, as shown in FIG. 7(F), the mask 180 is placed on the first inner surface 113. Then, as shown in FIG. 7(G), a first metal paste 149, which will become the wick 130, is applied. At this stage, a portion of the first metal paste 149 is also deposited on the first and second supports 1123, 1124.

Next, as shown in FIG. 7(H), the first metal paste 149 is sintered by heating it under predetermined conditions (details to follow) in a sintering furnace (not shown), thereby forming the wick 130. This wick 130 is secured to the first bottom surface 114, the first support 1123, and the second support 1124.

### <Step of Forming Bonding Member 150>

Referring next to FIG. 8, the step of forming the bonding member 150 on the second side plate 121 will be described. In the following steps, the second recess 120, the third support 1223, and the fourth support 1224 are first formed in the second side plate 121, and then the bonding member 150 is formed on the second recess 120.

First, steps of forming the second recess 120, the third support 1223, and the fourth support 1224 in the second side plate 121 will be described. Specifically, as shown in FIG. 8(A), the second side plate 121 is placed on the support table TB. It should be noted that the following steps are carried out while the second side plate 121 is on the support table TB, although it is not illustrated in FIGS. 8(B) to 7(H).

Next, as shown in FIG. 8(B), the region of the second inner surface 123 other than those where the third and fourth supports 1223, 1224 are to be formed is covered with a third masking member M21. Then, as shown in FIG. 8(C), the second side plate 121 is etched, followed by removing the third masking member M21. The regions etched in this step form the third and fourth support upper surfaces 1233, 1234.

Next, as shown in FIG. 8(D), the region of the second inner surface 123 other than the region where the second bottom surface 124 of the second recess 120 is to be formed is covered with a fourth masking member M22. Then, as shown in FIG. 8(E), the second side plate 121 is etched, followed by removing the fourth masking member M22. The region etched in this step forms the second bottom surface 124. As a result of this step, the second recess 120, the third support 1223, and the fourth support 1224 are now formed in the second side plate 121.

Next, the bonding member 150 is formed on the second recess 120. Specifically, as shown in FIG. 8(F), a fifth masking member M23 is placed on the first inner surface 113. Then, as shown in FIG. 8(G), a second metal paste 159, which will become the bonding member 150, is applied.

Next, as shown in FIG. 8(H), the second metal paste 159 is sintered by heating it under predetermined conditions (details to follow) in the sintering furnace (not shown), thereby forming the bonding member 150. This bonding member 150 is secured to the second bottom surface 124, the third support 1223, and the fourth support 1224.

### <Step of Joining Wick 130 and Bonding Member 150>

Referring next to FIG. 9, the step of joining the wick 130 and the bonding member 150 will be described.

First, as shown in FIG. 9(A), the first side plate 111 and the second side plate 121 are stacked face-to-face. This causes the wick 130 and the bonding member 150 to face and abut against each other. Then, as shown in FIG. 9(B), pressure is applied to the first and second side plates 111, 121 (see arrows F11 in the figure) to reduce the thickness of the wick 130, followed by heating the first and second side plates 111, 121 in the sintering furnace (not shown). This results in the wick 130 and the bonding member 150 being joined together.

Next, as shown in FIG. 9(C), after removal from the furnace, a treatment is applied to enhance the airtightness. Specifically, a laser beam LA is emitted onto the first and second side plates 111, 121. This causes the first and second side plates 111, 121 to be joined together, further enhancing the airtightness. In the illustrated example, a gap GA is created between the wick 130 and the first and second side plates 111, 121 in a region where the first and second supports 1123, 1223 face each other. Similarly, a gap GA is created in a region where the second and fourth supports 1124, 1224 face each other.

Next, as shown in FIG. 9(D), portions (specific regions) of the first and second side plates 111, 121 are pressed. Specifically, using a press machine (not shown), pressure is applied to the regions in the first and second side plates 111, 121 where the first and second supports 1123, 1223 face each other and where the second and fourth supports 1124, 1224 face each other (see arrows F13 in the figure). As a result, as shown in FIG. 9(E), the region where the first and third supports 1123, 1223 face each other is compressed, reducing the gap GA (in the illustrated example, eliminating the gap GA). Thus, the region where the first and third supports 1123, 1223 face each other is now filled with the wick 130. Similarly, the gap GA is reduced in the region where the second and fourth supports 1124, 1224 face each other, resulting in the region being filled with the wick 130. Although not described above, a first groove 1127 and a second groove 1128, which are recesses (pressure marks), are formed in the pressed specific regions. These first and second grooves 1127, 1128 facilitate heat transfer to the wick 130. To further illustrate, for example, due to the heating during the step of joining the wick 130 and the bonding member 150, components of the bonding member 150 may diffuse into the second side plate 121, potentially reducing the strength of the housing 100. However, forming the first and second grooves 1127, 1128 by applying pressure to the specific regions of the first and second side plates 111, 121 may prevent such reduction in strength of the housing 100.

In the illustrated example, as shown in FIGS. 7(H) and 8(H), the first and second metal pastes 149, 159 are heated for sintering while the first and second side plates 111, 121 are supported on the support table TB, which has a flat surface. This may effectively prevent deformation of the first and second side plates 111, 121 that may otherwise be caused by the heating, compared to when the first and second side plates 111, 121 are not supported by the support table TB.

Now, in the illustrated example, as shown in FIG. 7(H), the first side plate 111 is heated to form the wick 130. Also, as shown in FIG. 8(H), the second side plate 121 is heated to form the bonding member 150. Here, by applying heat treatment to at least one of the first and second side plates 111, 121, the reflectance of each of the first and second side plates 111, 121 for the laser beam LA decreases (i.e., the absorption rate increases). Such change in reflectance enables more reliable joining of the first and second side plates 111, 121 by the laser beam LA. The heat treatment step shown in FIG. 7(H) or FIG. 8(H) can be viewed as a step of performing a pretreatment for laser welding. In other words, the heat treatment step shown in FIG. 7(H) or FIG. 8(H) can be viewed as a step in which the copper plate is pre-treated along with sintering the wick 130 or the bonding member 150.

As described above and as shown in FIG. 9(D), pressing both ends in the width direction of the wick 130 enables more reliable contact between the wick 130 and the first recess 110 (or the second recess 120). In other words, this pressing prevents the creation of gaps at both ends in the width direction of the wick 130. Here, the first metal paste 149, which will become the wick 130 through sintering as described above, is applied to the first side plate 111 via the mask 180, as shown in FIG. 7(G). During this application, both ends in the width direction of the first metal paste 149 may separate from the first recess 110 due to phenomena such as so-called sagging.

In the present embodiment, in order to prevent gaps at both ends in the width direction of the first metal paste 149, the first and second supports 1123, 1124 are formed. That is, a portion of the first metal paste 149 is deposited on the first and second supports 1123, 1124, which are raised portions. This ensures that the first metal paste 149 reaches both ends in the width direction, even if, for example, the above coating using the rubber blade is insufficient.

In the present embodiment, after the first metal paste 149 is sintered as shown in FIG. 7(H) and joined to the bonding member 150, pressure is applied to the regions of the first and second supports 1123, 1124, as shown in FIG. 9(D). This pressure prevents gaps at both ends in the width direction of the wick 130. Here, in the illustrated example, pressure is applied to the regions where the first and second supports 1123, 1124 are formed, i.e., the regions that are thicker than the region where the first bottom surface 114 is formed. Applying pressure to such thicker regions prevents breakage and other damage that may otherwise result from applying pressure to thinner regions. To elaborate, in the illustrated example, portions of the copper plate on which both ends in the width direction of the wick 130 are to be disposed are given a stepped profile to increase the bottom thickness, thereby allowing for compression forming. To further illustrate, the first and second supports 1123, 1124 can be viewed as reinforcing portions.

### <First Metal Paste 149 and Second Metal Paste 159>

For example, the first and second metal pastes 149, 159 may be prepared as follows. The first metal paste 149, which will become the wick 130, can be prepared by mixing pure copper powder with a grain size of 45 µm or less into a binder solution. The second metal paste 159, which will become the bonding member 150, can be prepared by mixing bronze powder with a grain size of 45 µm or less into a binder solution. However, the above particle size and material of the metal powder used for the first metal paste 149, which will become the wick 130, and for the second metal paste 159, which will become the bonding member 150, are merely examples and not limiting. The binder solution consists of a binder component and an organic solvent. The binder component can be selected from, but is not limited to, acrylic, butyral, and cellulose-based components. The organic solvent can be selected from, but is not limited to, acetone, benzene, isopropanol, methanol, ethanol, toluene, n-butanol, xylene, ethylene glycol, ethyl acetate, terpineol, butyl acetate, tetrahydrofuran (THF), carbon tetrachloride, methyl ethyl ketone (MEK), chloroform, methyl isobutyl ketone (MIBK), n-hexane, methanol, and cyclohexane.

The first and second metal pastes 149, 159 are debinded and sintered in a mesh belt sintering furnace. Here, the first and second metal pastes 149, 159 deposited (applied) on the first and second side plates 111, 121, respectively, are sintered under the following conditions, for example. For the first metal paste 149, the debinding temperature may be 400°C to 600°C, the sintering temperature may be 700°C to 1050°C, the hold time may be 10 to 40 minutes, and the atmosphere gas may be 10% to 95% nitrogen and 5% to 90% hydrogen. For the second metal paste 159, the debinding temperature may be 400°C to 600°C, the sintering temperature may be 500°C to 700°C, the hold time may be 10 to 60 minutes, and the atmosphere gas may be 10% to 95% nitrogen and 5% to 90% hydrogen. The atmosphere for degreasing and sintering is not limited to the mixed nitrogen-hydrogen atmosphere; the atmosphere may also be a pure hydrogen, argon, mixed argon-hydrogen, or vacuum atmosphere. However, the above debinding and sintering conditions are merely examples that may be employed when using pure copper powder with a grain size of 45 µm or less for the first metal paste 149 to form the wick 130 and using bronze powder with a grain size of 45 µm or less for the second metal paste 159 to form the bonding member 150. These conditions may be appropriately selected depending on the metal powder material and binder components used.

### <Securing of First Side Plate 111 and Second Side Plate 121>

As shown in FIG. 9(B), the first and second side plates 111, 121 are secured, for example, under the following conditions. First, with the first and second side plates 111, 121 stacked face-to-face, pressure is applied from outside to the portions where the wick 130 and the bonding member 150 are formed (see arrows F11 in the figure) to adjust the combined thickness of the wick 130 and the bonding member 150 to equal the height of the flow path.

Next, the wick 130 and the bonding member 150 are bonded together in a mesh belt sintering furnace. The bonding is carried out, for example, under the following heat treatment conditions. That is, the temperature may be 500°C to 700°C, the hold time may be 10 to 40 minutes, and the atmosphere gas may be 10% to 95% nitrogen and 5% to 90% hydrogen. The atmosphere is not limited to the mixed nitrogen-hydrogen atmosphere, and may also be a pure hydrogen, argon, mixed argon-hydrogen, or vacuum atmosphere. Additionally, the first and second side plates 111, 121 are sandwiched by ceramic plates, and heat treatment is applied with a weight load of 1 kg.

Thereafter, with the wick 130 and the bonding member 150 bonded together, the first and second side plates 111, 121 are bonded together by layer welding of the outer surface of the first side plate 111 or the second side plate 121, in particular their outer peripheral edge, inner peripheral edge, and, when necessary, support posts 210. At this stage, in order to improve weldability, laser welding is performed using a jig (not shown) that ensures tight contact between the first and second side plates 111, 121.

In the above example, the wick 130 and the bonding member 150 are bonded in the mesh belt sintering furnace before laser welding the first and second side plates 111, 121. However, the first and second side plates 111, 121 may be laser welded before bonding the wick 130 and the bonding member 150 in the mesh belt sintering furnace.

The loop heat pipe 1 produced under the above conditions was leak tested, which showed that there were no problems with degassing. In addition, heat load testing on the produced loop heat pipe 1 proved that it could operate at 4.5W to 10W.

### <Bonding with Bonding Member 150>

As described above, the wick 130 and the second side plate 121 are secured to each other via the bonding member 150. This securing with the bonding member 150 will now be described.

First, as shown in FIG. 7(H), the wick 130 formed by sintering the first metal paste 149 is bonded at its first face side in the thickness direction (lower side in the figure) to the first side plate 111. Additionally, the wick 130 is required to be bonded (sealed) at its second face side in the thickness direction (upper side in the figure) to the second side plate 121. If, unlike the present embodiment, solder (e.g., 500°C) is used instead of the bonding member 150 to bond the wick 130 to the second side plate 121, the solder might be absorbed by the wick 130, with the consequent risk of degrading the function of the wick 130. Also if, unlike the present embodiment, brazing (e.g., 800°C) or diffusion bonding (e.g., 1000°C) is used to bond the wick 130 to the second side plate 121, the flow path for the working fluid might be blocked due to deflection or other deformation of the first and second side plates 111, 121.

Hence, in the illustrated example, the bonding member 150 is used for bonding. The bonding member 150 is made of a material (e.g., bronze) whose melting point is equal to or lower than that of the material of the wick 130 (e.g., pure copper). The bonding member 150 may be made of any material that is easily alloyed with or compatible with the wick 130 and the second side plate 121. For example, when the wick 130 is made of pure copper, brass or other material may be used as the bonding member 150. The material of the bonding member 150 can be viewed as one that has the same composition (e.g., copper) as the wick 130 and the second side plate 121. The material of the bonding member 150 can also be viewed as one whose melting point is equal to or lower than that of the alloy of the second side plate 121. In the above example, the sintering of the first metal paste 149, or the first heating, is carried out at 700°C to 1050°C. The bonding of the wick 130 and the bonding member 150, or the second heating, is carried out at 500°C to 700°C, which is lower than the temperature of the first heating. This reduces possible changes in structure of the wick 130 due to the second heating.

As described above, the bonding of the wick 130 and the bonding member 150 allows the wick 130 to be secured to both the first and second side plates 111, 121. The secured wick 130 and bonding member 150 serve as a pressure bulkhead between the vapor space 140 and the liquid reservoir 160.

### <Detailed Configuration of Wick 130>

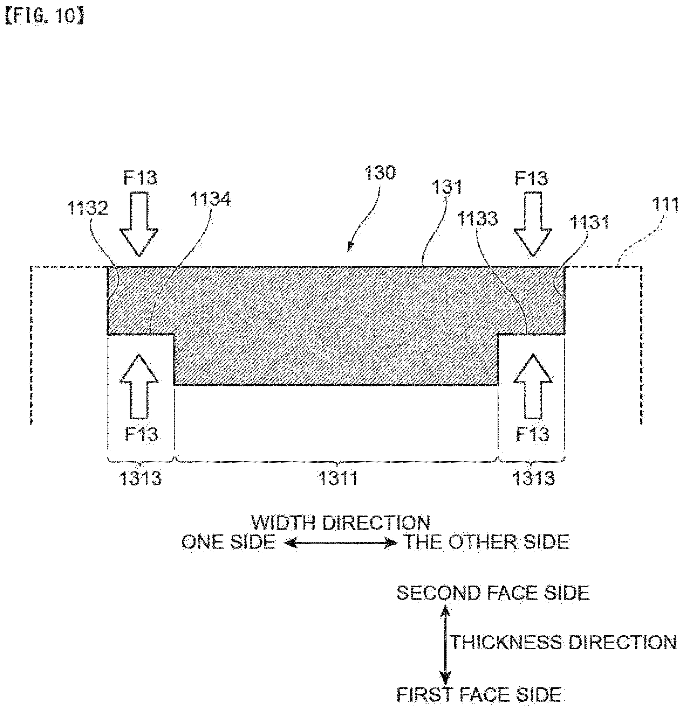

FIG. 10 illustrates a configuration of the wick 130.

Referring now to FIG. 10, a configuration of the wick 130 will be described.

As shown in FIG. 10, the wick 130 can be viewed as having a central portion 1311 in the width direction and end portions 1313 located at both ends in the width direction of the central portion 1311. Here, as described above with reference to FIG. 9(D), the end portions 1313 are portions of the wick 130 to which pressure has been applied. The end portions 1313 have a lower porosity than the central portion 1311. Additionally, the end portions 1313 have a smaller effective pore size than the central portion 1311.

The end portions 1313 have smaller voids in the wick 130 and thus have, for example, a larger contact area with the first side plate 111. In other words, the wick 130 can increase the heat-receiving area from the heating element. To further illustrate, since the wick 130 is made of a porous metal, it can be easily deformed by applying pressure, compared to non-porous metals.

As described above, the end portions 1313 have been compressed by applying pressure, so that they have a lower porosity than the central portion 1311. Accordingly, the behavior of the working fluid in the end portions 1313 may differ from that in the central portion 1311. Thus, in the illustrated example, the area (dimensions) of the compressed end portions 1313 is kept limited. Specifically, among the multiple wick prongs 133 of the wick 130, pressure is applied to only one wick prong 133 located at each end in the width direction. This may secure a large area in the wick 130 where no pressure is applied.

### <Configuration of Support Posts 210>

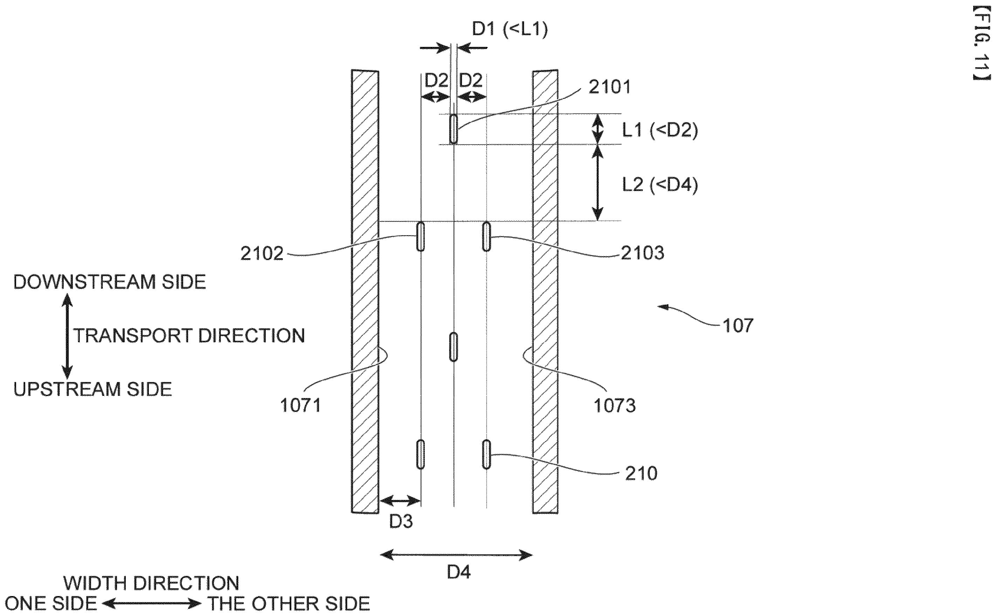

FIG. 11 illustrates a configuration of the support posts 210.

Referring now to FIG. 11, a configuration of the support posts 210 will be described. The following description discusses the support posts 210 formed in the condenser 107.

The support post 210 is a structure (so-called pillar) that supports the interior of the condenser 107. In the illustrated example, the support post 210 is a columnar body with a substantially elliptical cross-section. In the illustrated example, multiple support posts 210 are arranged in a predetermined pattern. To elaborate, in the illustrated example, a combination of two support posts 210 and one support post 210 is arranged at every first interval L2 along the transport direction. More specifically, arrangement of one support post 210 (first support post 2101) at the center in the width direction of the condenser 107 and arrangement of two support posts 210 (second support post 2102 and third support post 2103) on opposite sides with respect to the center in the width direction are alternated along the transport direction. Here, each of the second and third support posts 2102, 2103 is formed at a position spaced by a predetermined second interval D2 from the support post 210 located at the center in the width direction. Also, each of the second and third support posts 2102, 2103 is formed at a position located at a distance D3 away from the inner wall 1071 or 1073 of the condenser 107, where the distance D3 is one-fourth of the length D4 of the condenser 107 in the width direction.

To further elaborate on the configuration of the support posts 210, the length D1 in the width direction of each support post 210 is, e.g., 0.25 mm. This length D1 in the width direction is greater than the plate thickness of the first and second side plates 111, 121, which is 0.15 mm. Making the length D1 in the width direction of the support post 210 greater than the plate thickness of the first and second side plates 111, 121 in this manner ensures the strength of the support post 210.

The length L1 in the transport direction of the support post 210 is 1.1 mm. This length L1 in the transport direction of the support post 210 is greater than its length D1 in the with direction. This allows the support post 210 to guide the working fluid. Here, a greater length L1 in the transport direction of the support post 210 than a predetermined length can increase the bonding strength after laser welding. For example, when the support posts 210 are bonded by being heated with the laser beam LA emitted from outside the first and second side plates 111, 121 as in the above example shown in FIG. 9(C), heating is performed while moving the laser spot of the laser beam LA along the transport direction (details to follow). During this heating with the laser beam LA, the laser output may become unstable at the time of starting and ending the emission of the laser beam LA. Hence, making the length L1 in the transport direction of the support post 210 greater than a predetermined length may allow for more reliable bonding of the support posts 210, even if the laser spot of the laser beam LA is moved along the transport direction.

Meanwhile, a greater length L1 in the transport direction of the support post 210 leads to longer exposure to the laser beam LA, resulting in greater thermal deformation of the first and second side plates 111, 121. In the illustrated example, the first and second side plates 111, 121 are thin plates, so that they are more likely to have deformation due to exposure to the laser beam LA. In the illustrated example, the length L1 in the transport direction is made smaller than the second interval D2, thereby reducing the amount of heat generated by heating with the laser beam LA.

In addition, a greater length L1 in the transport direction of the support post 210 leads to a state where the flow path of the working fluid is divided into multiple sections in the width direction. If multiple flow paths are formed in this manner, the pressure within each flow path may vary, potentially causing reverse flow of the working fluid in some of the flow paths, which may obstruct the flow of the working fluid. In the illustrated example, the length L1 in the transport direction of the support post 210 is made smaller than the second interval D2, thereby preventing the flow of the working fluid from being obstructed.

In the width direction, the second interval D2 between the first support post 2101 and the second support post 2102 (or the third support post 2103) is 1.4 mm. In the transport direction, the first interval L2 between the first support post 2101 and the second support post 2102 (or the third support post 2103) is 3.9 mm. This first interval L2 is shorter than the length D4 in the width direction of the condenser 107, which is 6 mm. As a result, the distance over which the working fluid can freely move in the transport direction is shorter than the distance in the width direction. Additionally, in the illustrated example, the first interval L2 is longer than the length L1 in the transport direction of the support post 210. This permits the working fluid to move in the width direction.

In addition, an increase in volume of the support posts 210 inside the housing 100 leads to a reduced flow path for the working fluid. Furthermore, the presence of the support posts 210 acts as flow resistance against the working fluid. Thus, it is preferable to limit the size and number of the support posts 210. Meanwhile, in terms of the way in which the support posts 210 are arranged, dispersing the support posts 210, i.e., avoiding their uneven distribution, ensures that the interior of the housing 100 is more reliably supported. In the illustrated example, the support posts 210 are arranged in a repeated pattern of two followed by one along the transport direction. Such a regular arrangement of the support posts 210 helps maintain the strength of the housing 100. Such a regular arrangement of the support posts 210 also simplifies the fabrication process of the posts 210 and secures the volume inside the housing 100. Any process may be used to form the support posts 210 (first and second support posts 211, 221) on the first and second side plates 111, 121. For example, as shown in FIGS. 7(B) and 8(B), the regions where the first support posts 211 are to be formed may be covered with the first mask member M11 to form the first support posts 211 along with the first and second supports 1123, 1124 by etching. Alternatively, the first support posts 211 may be formed by an etching process separate from the one used for forming the first and second supports 1123, 1124, or the first support posts 211 may be formed by laser processing or other techniques.

### <Steps for Forming Support Posts 210>

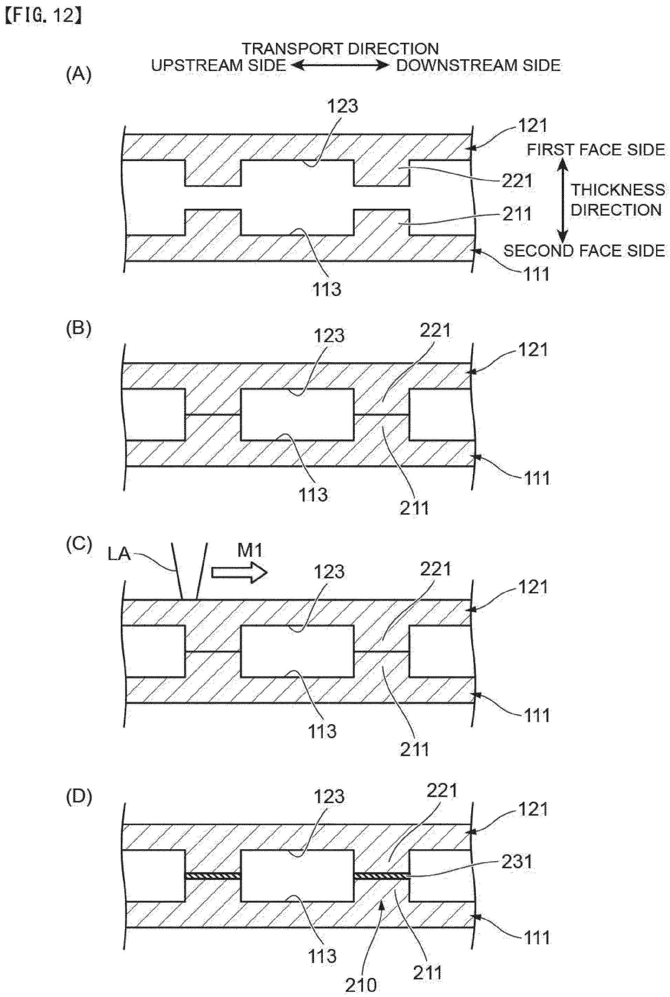

FIG. 12 illustrates steps for forming the support posts 210.

It should be noted that in FIG. 12, the vertical dimension of each component is particularly exaggerated (enlarged). FIG. 12(A) shows the first and second support posts 211, 221 and their surrounding structure in the step shown in FIG. 9(A). That is, FIG. 12(A) corresponds to the step shown in FIG. 9(A). Similarly, FIG. 12(B) corresponds to the step shown in FIG. 9(B), FIG. 12(C) corresponds to the step shown in FIG. 9(C), and FIG. 12(D) corresponds to the step shown in FIG. 9(E).

Referring now to FIG. 12, steps for forming the support posts 210 according to the present embodiment will be described.

First, as shown in FIG. 12(A), the first side plate 111 and the second side plate 121 are stacked face-to-face. This brings the first and second support posts 211, 221, which are respectively formed on the first and second side plates 111, 121, into facing relationship with each other. Thus, as shown in FIG. 12(B), the distal ends of the first and second support posts 211, 221 come into abutting contact.

Next, as shown in FIG. 12(C), a laser beam LA is emitted from outside the first and second side plates 111, 121 to heat the first and second support posts 211, 221. In this step, the laser spot of the laser beam LA is moved along the transport direction (see arrow M1). Moving the laser spot of the laser beam LA in this manner may make it possible to heat the entire length of the first and second support posts 211, 221 extending in the transport direction. Then, as shown in FIG. 12(D), portions of the first and second support posts 211, 221 are melted to form a joint 231. Thus, the first and second support posts 211, 221 are connected, or in other words, a support post 210 is formed.

### <Fin 310>

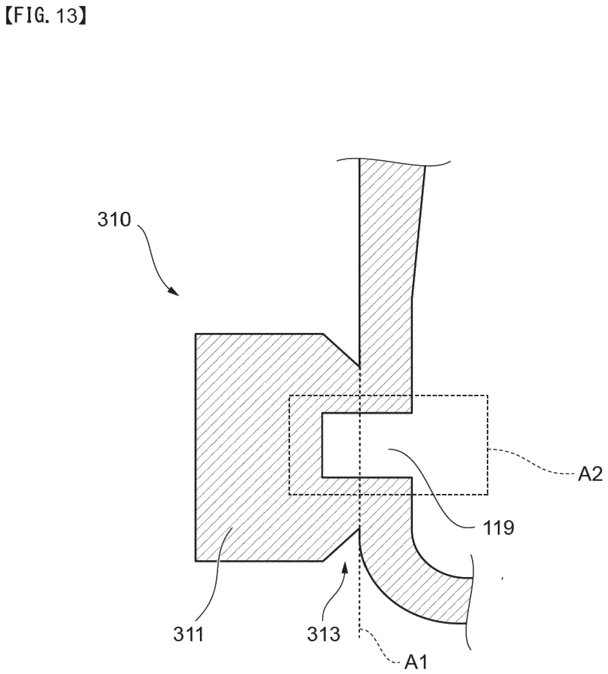

FIG. 13 illustrates a configuration of a fin 310.

Referring now to FIG. 13, a configuration of a fin 310 will be described.

First, the fin 310 serves as a sealing structure to seal the loop heat pipe 1. The fin 310 includes a fin main body 311, which is a substantially rectangular plate-shaped member, and cut-outs 313 formed at the base of the fin main body 311.

As described above, the steps for manufacturing the loop heat pipe 1 includes the filling step of filling the working fluid into the housing 100 (composed of the first and second side plates 111, 121). After the filling step, a portion of the fin 310 is sealed and cut.

First, to elaborate on the filling step, a metal tube (not shown) that serves as a flow path for the working fluid is connected to the first opening region 119. Specifically, in the state where the metal tube is connected to the first opening region 119, the metal tube is inserted between two fin main bodies 311. At this stage, the fin main bodies 311 hold the metal tube in place, thereby preventing it from coming off from the first opening region 119.

The next step of sealing and cutting off the fin 310 proceeds as follows. First, a portion of the fin main body 311 is pressed (crushed) along a virtual line A1 passing through the base of the fin main body 311. In other words, the base of the fin main body 311 is subjected to so-called crimping. Then, the surrounding region A2 of the first opening region 119 is welded using laser. That is, the crimped region is further subjected to laser welding. This ensures more reliable sealing. Subsequently, the fin main body 311 is cut along the virtual line A1 using a well-known cutting technique such as pressing or laser processing. Cutting off the fin main body 311 after filling the working fluid simplifies the shape of the loop heat pipe 1.

### <Electronic Device>

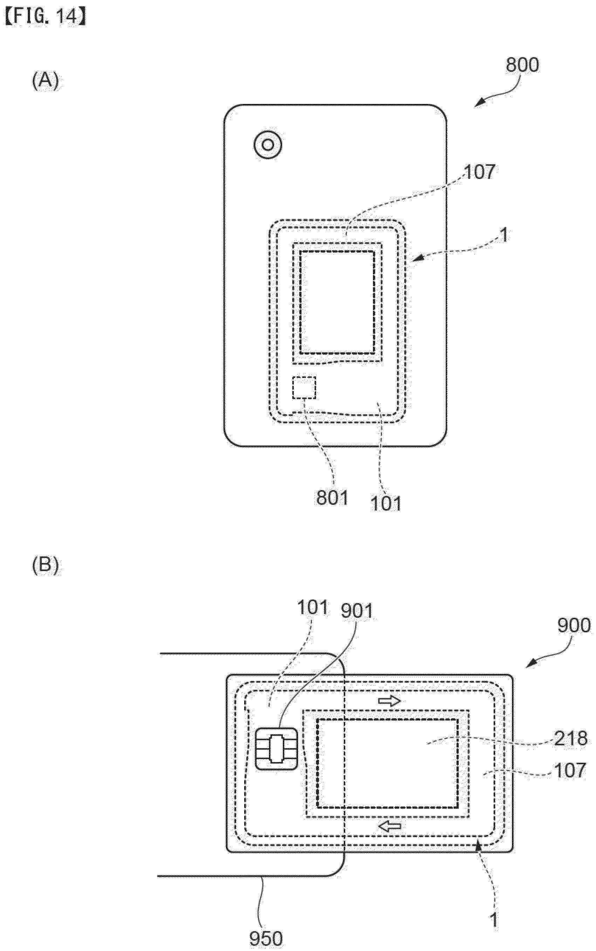

FIG. 14 illustrates a device equipped with the loop heat pipe 1.

Referring now to FIG. 14, a device equipped with the loop heat pipe 1 will be described.

As shown in FIG. 14(A), the loop heat pipe 1 is provided in an electronic device such as a mobile phone 800. The depicted mobile phone 800 is a so-called smartphone. The mobile phone 800 includes a central processing unit (CPU) 801, which is an example of the heating element, and the loop heat pipe 1 to cool the CPU 801. The heat generated by the CPU 801 is controlled by the loop heat pipe 1. The mobile phone 800 is manufactured by providing the CPU 801 on the loop heat pipe 1.

The loop heat pipe 1 does not require an external power supply, as described above. In other words, it can operate without power. In addition, the loop heat pipe 1 may enable a long-distance heat transport (e.g., 100 mm to 1 m) and a highly efficient heat transport using latent heat. In addition, the thin profile of the loop heat pipe 1 offers layout flexibility.

In recent years, the introduction of the so-called 5th generation mobile communication system (5G) and other factors have led to an increased demand for high-frequency communications (3.7, 4.5, and 28 GHz). Additionally, for example, densification through the addition of more components, higher CPU and GPU processing power requirements, increased heat density, and increased heat transport are required of smartphones and tablet terminals such as the mobile phone 800. The loop heat pipe 1 described above is a device that may meet these performance requirements.

While the mobile phone 800 has been described as an example of the electronic device, the above loop heat pipe 1 may be provided in personal computers, tablet terminals, projectors, etc. The loop heat pipe 1 may also be provided in various devices such as electronic control units (ECUs) and batteries installed in automobiles etc., or satellites.

As shown in FIG. 14(B), the loop heat pipe 1 may also be installed in a card 900, which is an example of the device. The depicted card 900 is a so-called smart card, whose specifications are defined by an international standard (ISO/IEC7810).

Smart cards are generally classified into contact and contactless types. Inside the card are 0.4-mm or less thick devices, such as IC chips, near field communication (NFC) antennas, Bluetooth^{®} communication, fingerprint sensors, displays, power supply ICs, DC/DC converters, batteries and capacitors, which are incorporated as needed. In the future, along with the increased performance of IC chips and various devices, smart cards are expected to be used like a PC. The driving power for the PC is received through a card reader 950 in the case of a contact type, and through the NFC antenna in the case of a contactless type. As a CPU 901 for the PC generates more heat with an increase in computing speed, a cooling mechanism needs to be provided within the card 900.

The loop heat pipe 1, which is 0.3 mm thick for example, can be incorporated into the card 900. The loop heat pipe 1 may be configured to reject heat by exposing one or more surfaces of the condenser 107 (e.g., the condensation surface) to the outside of the card 900. To further illustrate, the loop heat pipe 1 can be an effective solution to design problems where the card 900 is of a contact type and the CPU 901 for the PC has to be located in a region of the card 900 that will be inside the card reader 950. In the illustrated example, elements necessary for a smart card may be disposed in the through-hole 218 of the loop heat pipe 1. Examples of these elements include batteries, CPUs, RAMs, ROMs, coprocessors, non-volatile memories (EEPROMs), and interfaces (I/Fs). The dimensions of the through-hole are 38 mm in the width direction and 27 mm in the transport direction, for example.

### <Variants>

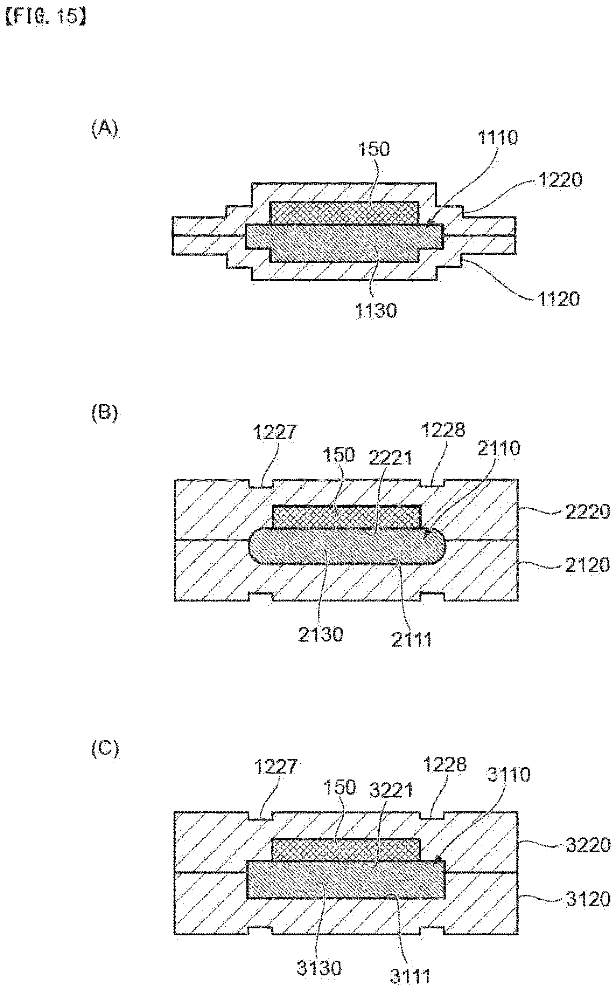

FIG. 15 illustrates variants of the present embodiment.

Referring now to FIG. 15, variants of the present embodiment will be described. In the following description, components identical to those in the above embodiment are identified with the same reference numerals, and detailed explanations thereof may be omitted.

In the above description of FIG. 5(B), the thickness of the second support 1124, which is located on the outer side of the first recess 110 formed in the first side plate 111, has been described as being greater than that of the center of the first recess 110. However, this implementation is not limiting. For example, as shown in FIG. 15(A), a first side plate 1120 may have a constant thickness at the outer sides and center of a first recess 1110. In the illustrated example, a second side plate 1220 also has a constant thickness at the outer sides and center of the first recess 1110. A wick 1130 is disposed within the first recess 1110.

In the above description of FIG. 5(B), a stepped profile such as the second support 1124 has been described as being formed on the outer side of the first recess 110 formed in the first side plate 111. However, this implementation is not limiting. For example, as shown in FIG. 15(B), a first recess 2110 formed in a first side plate 2120 may have a curved bottom surface 2111. In the illustrated example, a first recess 2110 formed in a second side plate 2220 also has a curved bottom surface 2221. A wick 2130 is disposed within the first recess 2110.

In the above description of FIG. 9(E), the region where the first and third supports 1123, 1223 face each other and the region where the second and fourth supports 1124, 1224 face each other in the first and second side plates 111, 121 have been described as being subjected to pressure. Here, the first to fourth supports 1123 to 1224 may be omitted in a configuration where pressure is applied to the outer sides of the first recess 1110. For example, as shown in FIG. 15(C), a first recess 3110 formed in a first side plate 3120 may have a flat bottom surface 3111. In the illustrated example, a first recess 3110 formed in a second side plate 3220 also has a flat bottom surface 3221. A wick 3130 is disposed within the first recess 3110, and pressure is applied to the ends of the wick 3130 together with the first and second side plates 3120, 3220, resulting in formation of the first groove 1127 and the second groove 1128.

In the above description, the first groove 1127 or the second groove 1128 has been described as being formed on both the first and second side plates 3120, 3220 by pressing them from both sides. However, this implementation is not limiting. For example, an implementation is possible where one of the first and second side plates 3120, 3220 is pressed against a flat surface, while pressure is applied to the other at the outer sides of its first recess 1110. In such an implementation, either the first side plate 3120 or the second side plate 3220 will have the first grooves 1127 and the second grooves 1128 or the first grooves 1227 and the second grooves 1228 formed thereon.

### <Other Variants>

In the above description with reference to FIG. 9D, portions (specific regions) of the first and second side plates 111, 121 have been described as being pressed. However, an implementation is also possible where the entire surfaces of the first and second side plates 111, 121 are pressed, provided that such pressing can reduce the gap GA, i.e., narrow the clearance. Still alternatively, the step of pressing the first and second side plates 111, 121 may be omitted if the gap GA is below a predetermined dimension.

In the above description, the distal ends of the first and second support posts 211, 221 have been described as being heated by laser welding or similar means to form the support post 210. However, this implementation is not limiting. For example, an implementation is also possible where the distal ends of the first and second support posts 211, 221 are bonded using another material such as an adhesive. Still alternatively, the distal ends of the first and second support posts 211, 221 may simply be brought into abutting contact with each other without being bonded.

In the above description, the support post 210 has been described as being of a columnar shape with a substantially elliptical cross-section. However, the support post 210 may be of any shape that allows it to support the space between the first and second side plates 111, 121. For example, the cross-section of the support post 210 may be a polygon such as a substantially rectangular shape, or may be circular.

In the above description, the support posts 210 have been described as being provided within the evaporator 101, the vapor line 105, the condenser 107, and the liquid line 109. However, this implementation is not limiting. For example, support posts 210 may be provided within any one of the evaporator 101, the vapor line 105, the condenser 107, and the liquid line 109. An implementation is also possible where no support posts 210 are provided within the evaporator 101, the vapor line 105, the condenser 107, and the liquid line 109.

In the above description of FIG. 4, the wick 130 has been described as having the wick protrusion 137 at the center in the width direction of the wick base 131. However, the configuration of the wick 130 is not limited to this. The wick protrusion 137 may be provided near an end portion of the wick base 131 in the width direction. Still alternatively, the wick 130 may not include the wick protrusion 137. While the wick protrusion 137 shown in FIG. 4 is substantially rectangular in a plan view, the wick protrusion 137 may be of any shape that facilitates the supply of working fluid to the wick base 131. For example, the width of the wick protrusion 137 may increase as one moves downstream in the transport direction. Still alternatively, the wick protrusion 137 may have a curved shape. Still alternatively, the wick 130 may include multiple wick protrusions 137.

In the above description, the wick 130 has been described as having an effective pore size of, for example, 0.1 to 50 µm. However, the effective pore size is not limited to this range. For example, in the case of a biporous wick, in which the wick 130 has pores with two different characteristic sizes, the peak value of the smaller effective pore size may be 3.5 to 49 µm. An implementation is also possible where the wick base 131, the wick prongs 133, and the wick protrusion 137 have different effective pore sizes. For example, the wick 130 may include the wick base 131 and the wick prongs 133 having a first pore size, and the wick protrusion 137 having a second average pore size that differs from (e.g., is larger than) the first pore size.

In the above description, the mask 180 is used to apply the wick 130. However, this implementation is not limiting. For example, instead of the mask 180, any well-known technique, such as a screen used for screen printing, a dispenser, or a masking tape, may be used to apply the wick 130 to a predetermined region. Alternatively, the wick 130 may be formed by forming a sheet (thin plate) of the wick material using a coater and then cutting it into a predetermined shape. The method for applying the bonding member 150 is also not limited.

In the above description, the wick 130 has been described as being formed by applying the material of the wick 130. However, the method for forming the wick 130 is not limited to this. For example, the wick 130 may be formed by depositing a powdered material of the wick 130 on the first side plate 111 and sintering it. For example, the powdered material may be spread at a thickness of about 0.3 mm on the first side plate 111 at locations where the wick 130 is to be formed. Alternatively, the wick 130 may be formed by creating pores in a plate-like member through an etching process. As in the above embodiment, combining the powdered material and a binder into a paste may enable a thin and uniform application of the material of the wick 130.

The material used as the wick 130 is not limited to the porous metal material described above. The wick 130 may be made of any other material, such as a porous ceramic material, porous glass material, or porous fiber, etc., that can be processed into powder and can secure the positions of the components relative to each other when heated.

In the above description, the first and second recesses 110, 120 and other components have been described as being formed by etching. However, this implementation is not limiting. For example, the first and second recesses 110, 120 may be formed by cutting, pressing, or performing any other well-known process on the first and second side plates 111, 121. Alternatively, only one of the first and second recesses 110, 120 may be formed, provided that a space for placement of the wick 130 and the bonding member 150 can be provided between the first and second side plates 111, 121. Note that forming the first recess 110 by etching as described above can roughen the first bottom surface 114, which may ensure more reliable securing of the wick 130 to the first side plate 111. Also, forming the second recess 120 by etching can roughen the second bottom surface 124, which may ensure more reliable securing of the bonding member 150 to the second side plate 121.

The first and second side plates 111, 121 are not limited to being generally plate-shaped, provided that they are configured to have a limited thickness dimension. For example, the first and second side plates 111, 121 may have unevenness on their plate surfaces or may have an additional component(s) secured to their plate surfaces. To further illustrate, the first and second side plates 111, 121 can be viewed as a main body and a lid body covering the main body, respectively. Alternatively, the loop heat pipe 1 may be formed by sandwiching a frame, separate from the first and second side plates 111, 121, between the first and second side plates 111, 121.

In the above description, the bonding member 150 has been described as being formed by applying the material of the bonding member 150 and then sintering it. However, this implementation is not limiting. For example, the bonding member 150 may be pre-formed as a plate-shaped member, and the plate-shaped bonding member 150 may be secured to the second side plate 121 and the wick 130 by being heated while being sandwiched by the second side plate 121 and the wick 130. Alternatively, unlike the illustrated example, the bonding member 150 may not be provided.

In the above description, the first and second side plates 111, 121 have been described as being bonded by laser welding. However, this implementation is not limiting. For example, the first and second side plates 111, 121 may be bonded by soldering or brazing, provided that it is possible to prevent the flow of solder or brazing material into the first and second recesses 110, 120. Alternatively, diffusion bonding may be used, provided that it is possible to prevent any blockage of the flow path. Still alternatively, bonding may be performed by adhesive bonding, ultrasonic bonding, or friction stir bonding.

In the above description, the loop heat pipe 1 has been described as an example of the heat exchanger. However, the heat exchanger is not limited to this and may be any other two-phase heat transport device. For example, the above configuration of the wick 130, the first side plate 111, etc. may be employed in other heat exchangers such as vapor chambers.

While the various embodiments and variants have been described above, it is readily understood that they may be combined with one another.

It is also understood that teachings of the present disclosure are in no way limited to the above embodiments, and may be implemented in various ways without departing from the scope of the present disclosure.

The loop heat pipe 1 is an example of the heat exchanger. The wick 130 is an example of the evaporating body. The first side plate 111 is an example of the main body. The second side plate 121 is an example of the lid body. The first recess 110 is an example of the recess. The first support 1123 is an example of the structural component. The first taper 1125 is an example of the inclined surface. The first metal paste 149 is an example of the material. The mobile phone 800 is an example of the device. The heating element 10 is an example of the heating component.

### Reference Signs List

- 100: Loop heat pipe
- 110: First recess
- 111: First side plate
- 121: Second side plate
- 130: Wick
- 149: First metal paste
- 180: Mask
- 1123: First support
- 1127: First groove

## Claims

1. A heat exchanger including an evaporator provided with an evaporating body, the evaporating body being configured to absorb heat from outside and evaporate a liquid-phase working fluid into a gas phase while moving the working fluid by capillary forces, the heat exchanger being configured to condense the gas-phase working fluid introduced from the evaporator and circulate the working fluid in a liquid phase back into the evaporator, wherein
the evaporator comprises:
a plate-shaped main body including a recess in a plate surface thereof, the recess being configured to accommodate the evaporating body; and
a lid body configured to cover the recess of the main body and the evaporating body accommodated in the recess,
the main body includes a structural portion configured to make an outer depth of the recess shallower than a center depth of the recess, and
an outer portion of the evaporating body accommodated in the recess is sandwiched by the structural portion and the lid body.

2. The heat exchanger according to claim 1, wherein the structural portion is a portion having a thickness greater than a thickness of a center bottom of the recess.

3. The heat exchanger according to claim 2, wherein the structural portion is a step formed at an end in an intersecting direction, the intersecting direction intersecting a flow direction in which the working fluid flows through the evaporating body.

4. The heat exchanger according to claim 3, further comprising an inclined surface located upstream of the structural portion in the flow direction, the inclined surface being inclined toward a center in the intersecting direction as one moves downstream in the flow direction.

5. The heat exchanger according to any one of claims 1 to 4, wherein an effective pore size of pores formed in the evaporating body is from 3.5 µm to 49 µm.

6. The heat exchanger according to claim 5, wherein an effective pore size in the outer portion of the evaporating body is smaller than an effective pore size in a center of the evaporating body.

7. A heat exchanger including an evaporator provided with an evaporating body, the evaporating body being configured to absorb heat from outside and evaporate a liquid-phase working fluid into a gas phase while moving the working fluid by capillary forces, the heat exchanger being configured to condense the gas-phase working fluid introduced from the evaporator and circulate the working fluid in a liquid phase back into the evaporator, wherein
the evaporator comprises:
a plate-shaped main body including a recess in a plate surface thereof, the recess being configured to accommodate the evaporating body; and
a lid body configured to cover the recess of the main body and the evaporating body accommodated in the recess, and
a pressure mark resulting from applying pressure to the main body, the lid body, and the evaporating body is formed on a plate surface of at least one of the main body and the lid body at a position outside a center of the recess.

8. A method for manufacturing a heat exchanger including an evaporator provided with an evaporating body, the evaporating body being configured to absorb heat from outside and evaporate a liquid-phase working fluid into a gas phase while moving the working fluid by capillary forces, the heat exchanger being configured to condense the gas-phase working fluid introduced from the evaporator and circulate the working fluid in a liquid phase back into the evaporator, wherein
the evaporator includes:
a plate-shaped main body including a recess in a plate surface thereof, the recess being configured to accommodate the evaporating body; and
a lid body configured to cover the recess of the main body and the evaporating body accommodated in the recess,
the method comprises steps of:
forming the recess in the main body and forming a structural portion configured to make an outer depth of the recess shallower than a center depth of the recess;
applying a material of the evaporating body to the recess and solidifying the material to form the evaporating body; and
covering the recess accommodating the evaporating body with the lid body and
sandwiching, by the structural portion and the lid body, an outer portion of the evaporating body accommodated in the recess.

9. The method according to claim 8, further comprising a step of pressing the outer portion of the evaporating body sandwiched by the structural portion and the lid body, along with pressing the main body and the lid body.

10. The method according to claim 8 or 9, wherein the structural portion is a portion having a thickness greater than a thickness of a center bottom of the recess.

11. The method according to claim 10, wherein the structural portion is a step formed at an end in an intersecting direction, the intersecting direction intersecting a flow direction in which the working fluid flows though the evaporating body along the bottom of the recess.

12. The method according to claim 11, wherein the heat exchanger further includes an inclined surface located upstream of the step in the flow direction, the inclined surface being inclined toward a center in the intersecting direction as one moves downstream in the flow direction.

13. The method according to claim 8, wherein an effective pore size of pores formed in the evaporating body is from 3.5 µm to 49 µm.

14. The method according to claim 13, wherein an effective pore size in the outer portion of the evaporating body is smaller than an effective pore size in a center of the evaporating body.

15. A method for manufacturing a heat exchanger including an evaporator provided with an evaporating body, the evaporating body being configured to absorb heat from outside and evaporate a liquid-phase working fluid into a gas phase while moving the working fluid by capillary forces, the heat exchanger being configured to condense the gas-phase working fluid introduced from the evaporator and circulate the working fluid in a liquid phase back into the evaporator, wherein
the evaporator comprises:
a plate-shaped main body including a recess in a plate surface thereof, the recess being configured to accommodate the evaporating body; and
a lid body configured to cover the recess of the main body and the evaporating body accommodated in the recess, and
the method comprises steps of:
forming the recess in the main body;
forming a structural body configured to make an outer depth of the recess shallower than a center depth of the recess and make a thickness of an outer bottom of the recess greater than a thickness of a center bottom of the recess;
applying a material of the evaporating body to the recess and solidifying the material to form the evaporating body;
covering the recess accommodating the evaporating body with the lid body; and
clamping each plate surface of the main body and the lid body covering the main body at portions thereof corresponding to an outer portion of the evaporating body accommodated in the recess, thereby compressing the evaporating body by the structural portion and the lid body.

16. A device comprising:
a heating element; and
a heat exchanger including an evaporator provided with an evaporating body, the evaporating body being configured to absorb heat from the heating element and evaporate a liquid-phase working fluid into a gas phase while moving the working fluid by capillary forces, the heat exchanger being configured to condense the gas-phase working fluid introduced from the evaporator and circulate the working fluid in a liquid phase back into the evaporator, wherein the evaporator comprises:
a plate-shaped main body including a recess in a plate surface thereof, the recess being configured to accommodate the evaporating body; and
a lid body configured to cover the recess of the main body and the evaporating body accommodated in the recess,
the main body includes a structural portion configured to make an outer depth of the recess shallower than a center depth of the recess, and
an outer portion of the evaporating body accommodated in the recess is sandwiched by the structural portion and the lid body.

17. A heat exchanger including an evaporator provided with an evaporating body, the evaporating body being configured to absorb heat from outside and evaporate a liquid-phase working fluid into a gas phase while moving the working fluid by capillary forces, the heat exchanger being configured to condense the gas-phase working fluid introduced from the evaporator and circulate the working fluid in a liquid phase back into the evaporator, wherein
the evaporator comprises:
a plate-shaped main body configured to accommodate the evaporating body, the main body being formed with a flow path for the working fluid on a plate surface thereof;
a lid body configured to cover the evaporating body, accommodated in the main body, and the flow path; and
a guide portion provided on a bottom of the flow path, the guide portion being configured to support the main body and the lid body within the flow path, the guide portion having a longitudinal direction extending along a flow direction of the working fluid, the guide portion being configured to guide the working fluid, and
a length of the guide portion in the flow direction is shorter than a length of the flow path in a width direction.

18. The heat exchanger according to claim 17, wherein a plurality of the guide portions are arranged at a predetermined interval along the flow direction.

19. The heat exchanger according to claim 18, wherein the predetermined interval is longer than the length of the guide portion in the flow direction.

20. The heat exchanger according to claim 17, wherein a plurality of sets of the guide portions are arranged along the flow direction, each of the sets including the guide portions located at different positions in the width direction.

21. The heat exchanger according to claim 17, wherein a length of the guide portion in the width direction is greater than a thickness of the main body.

22. The heat exchanger according to claim 17, wherein the guide portion is configured to connect the main body and the lid body in a thickness direction of the main body.

23. The heat exchanger according to claim 22, wherein the guide portion is configured to connect the main body and the lid body by being heated with a heating unit configured to heat the guide portion from outside the main body and the lid body while moving along the flow direction.

24. The heat exchanger according to claim 17, wherein the guide portion is provided inside the evaporator in which the evaporating body is provided.

25. The heat exchanger according to claim 17, further comprising a condenser configured to condense the working fluid in a gas phase discharged from the evaporator and circulate the working fluid back into the evaporator, wherein
the guide portion is provided inside the condenser.

26. The heat exchanger according to any one of claims 17 to 25, wherein an effective pore size of pores formed in the evaporating body is from 3.5 µm to 49 µm.

27. A heat exchanger including an evaporator provided with an evaporating body, the evaporating body being configured to absorb heat from outside and evaporate a liquid-phase working fluid into a gas phase while moving the working fluid by capillary forces, the heat exchanger being configured to condense the gas-phase working fluid introduced from the evaporator and circulate the working fluid in a liquid phase back into the evaporator, wherein
the evaporator comprises:
a plate-shaped main body configured to accommodate the evaporating body, the main body being formed with a flow path for the working fluid on a plate surface thereof;
a lid body configured to cover the evaporating body, accommodated in the main body, and the flow path; and
a guide portion provided on a bottom of the flow path, the guide portion being configured to support the main body and the lid body within the flow path, the guide portion having a longitudinal direction extending along a flow direction of the working fluid, the guide portion being configured to guide the working fluid,
a length of the guide portion in the flow direction is shorter than a length of the flow path in a width direction,
a length of the guide portion in the width direction is greater than a thickness of the main body, a plurality of the guide portions are arranged at a predetermined interval along the flow direction within the flow path and at different positions in the width direction depending on positions in the flow direction, and
the predetermined interval is longer than the length of the guide portion in the flow direction.

28. A method for manufacturing a heat exchanger including an evaporator provided with an evaporating body, the evaporating body being configured to absorb heat from outside and evaporate a liquid-phase working fluid into a gas phase while moving the working fluid by capillary forces, the heat exchanger being configured to condense the gas-phase working fluid introduced from the evaporator and circulate the working fluid in a liquid phase back into the evaporator, wherein
the evaporator comprises:
a plate-shaped main body configured to accommodate the evaporating body, the main body being formed with a flow path for the working fluid on a plate surface thereof;
a lid body configured to cover the evaporating body, accommodated in the main body, and the flow path; and
a guide portion provided on a bottom of the flow path, the guide portion being configured to support the main body and the lid body within the flow path, the guide portion having a longitudinal direction extending along a flow direction of the working fluid, the guide portion being configured to guide the working fluid,
a length of the guide portion in the flow direction is shorter than a length of the flow path in a width direction, and
the method comprises steps of:
forming the flow path and the guide portion in the main body;
covering the evaporating body accommodated in the main body and the flow path with the lid body; and
heating the guide portion, configured to connect the main body and the lid body within the flow path, using a heating unit configured to heat the guide portion from outside the main body and the lid body while moving along the flow direction, thereby connecting the main body and the lid body in a thickness direction of the main body.

29. A device comprising:
a heating element; and
a heat exchanger including an evaporator provided with an evaporating body, the evaporating body being configured to absorb heat from the heating element and evaporate a liquid-phase working fluid into a gas phase while moving the working fluid by capillary forces, the heat exchanger being configured to condense the gas-phase working fluid introduced from the evaporator and circulate the working fluid in a liquid phase back into the evaporator, wherein the evaporator comprises:
a plate-shaped main body configured to accommodate the evaporating body, the main body being formed with a flow path for the working fluid on a plate surface thereof;
a lid body configured to cover the evaporating body, accommodated in the main body, and the flow path; and
a guide portion provided on a bottom of the flow path, the guide portion being configured to support the main body and the lid body within the flow path, the guide portion having a longitudinal direction extending along a flow direction of the working fluid, the guide portion being configured to guide the working fluid, and
a length of the guide portion in the flow direction is shorter than a length of the flow path in a width direction.
